# EUROPEAN PATENT APPLICATION

(11) **EP 4 797 915 A1**
(43) Date of publication of application: **26.08.2026**
(21) Application number: 24884124.9
(22) Date of filing: 13.08.2024
(51) Int. Cl.: H10F 77/30, H10F 77/14, H10F 71/00

(54) **PEROVSKITE THIN FILM, PEROVSKITE CELL, PREPARATION METHOD, ELECTRIC DEVICE AND POWER GENERATION DEVICE**

(30) Priority: 31.10.2023 CN 202311435162
(71) Applicant: Contemporary Amperex Technology Co., Limited, Ningde, Fujian 352100 (CN)
(72) Inventor: ZHOU, Zichun, Ningde, Fujian 352100 (CN); LIN, Weile, Ningde, Fujian 352100 (CN); WANG, Shidan, Ningde, Fujian 352100 (CN); GUO, Yongsheng, Ningde, Fujian 352100 (CN); OUYANG, Chuying, Ningde, Fujian 352100 (CN)
(74) Representative: Gong, Jinping
(86) International application number: PCT/CN2024/111864
(87) International publication number: WO 2025/092117

(57) **Abstract**

The present application provides a perovskite thin film, a perovskite solar cell, a preparation method, a power consuming apparatus, and a power generation apparatus. A thickness direction of the perovskite thin film is recorded as a vertical direction. The perovskite thin film has two surfaces facing away from each other in the vertical direction. At least one surface is a non-smooth surface. The non-smooth surface is provided with a plurality of concave grooves. At least a portion of a side surface of each of the concave grooves forms an inclination angle relative to the vertical direction.

## Description

### CROSS-REFERENCE TO RELATED APPLICATIONS

The present application claims priority to Chinese Patent Application No. CN2023114351623, filed on October 31, 2023, and entitled "PEROVSKITE THIN FILM, PEROVSKITE SOLAR CELL, PREPARATION METHOD, AND POWER CONSUMING APPARATUS", which is incorporated herein by reference in its entirety.

### TECHNICAL FIELD

The present application relates to the field of solar cell technologies, and in particular, to a perovskite thin film, a perovskite solar cell, a preparation method, a power consuming apparatus, and a power generation apparatus.

### BACKGROUND

The statement herein merely provides background information related to the present application and does not necessarily constitute the prior art.

Perovskite solar cells are devices that convert solar energy into electricity using a photoelectric conversion mechanism of a perovskite crystalline material. As the current thirdgeneration solar cells, perovskite solar cells offer advantages such as high power conversion efficiency, simple manufacturing processes, and low production costs, and have attracted extensive research in recent years. One of the key research focuses is how to improve the short-circuit current density (Jsc) and power conversion efficiency (PCE) to enhance the comprehensive performance of devices.

### SUMMARY

According to various implementations and various embodiments of the present application, the present application provides a perovskite thin film, a perovskite solar cell, a preparation method, a power consuming apparatus, and a power generation apparatus. The perovskite thin film may be used as a light-absorbing layer of a perovskite solar cell, and can improve the comprehensive performance in terms of short-circuit current density (Jsc) and power conversion efficiency (PCE).

According to a first aspect, the present application provides a perovskite thin film. A thickness direction of the perovskite thin film is recorded as a vertical direction. The perovskite thin film has two surfaces facing away from each other in the vertical direction. At least one surface is a non-smooth surface. The non-smooth surface is provided with a plurality of concave grooves.

At least a portion of a side surface of each of the concave grooves forms an inclination angle relative to the vertical direction.

A surface of at least one side of the perovskite thin film is disposed as the non-smooth surface. The concave grooves are provided in at least some regions of the non-smooth surface. In this case, trench-shaped elongated concave portions are introduced into the surface of the thin film, so that at least a portion of the side surface of each of the concave grooves forms the inclination angle relative to the vertical direction. Through the reflection of incident light by the side surfaces of the concave portions, chances of contact between photons and the perovskite thin film at interfaces of the concave grooves can be increased, and a light re-incidence ratio can be improved, thereby increasing a total amount of light entering the perovskite thin film and enhancing the utilization of incident light, so that the comprehensive performance in terms of short-circuit current density and power conversion efficiency of the perovskite solar cell can be improved.

Based on any appropriate implementation in the present application, in some further implementations, surface roughness of non-smooth regions formed by at least some of the concave grooves is greater than or equal to 100 nm.

Optionally, surface roughness of non-smooth regions formed by at least some of the concave grooves ranges from 100 nm to 250 nm.

Optionally, the surface roughness is measured using stylus profilometry.

A distribution quantity of the concave grooves on the surface of the perovskite thin film may affect the surface roughness of the perovskite thin film. The concave groove can be controlled to have a more appropriate morphology by controlling the surface roughness in the non-smooth regions in the non-smooth to fall within the foregoing ranges, which is beneficial to enhancing the light-trapping effect of the concave grooves, thereby further improving the comprehensive performance in terms of short-circuit current density and power conversion efficiency.

Based on any appropriate implementation in the present application, in some further implementations, a percentage of a sum of areas of the concave grooves on the non-smooth surface relative to an area of the non-smooth surface is greater than or equal to 10%, optionally greater than or equal to 30%, and further optionally greater than or equal to 50%.

The amount of light trapped by the concave grooves may be adjusted by adjusting an area percentage of the concave grooves to the surface of the perovskite thin film. A percentage of a sum of projection areas of the concave grooves in the thickness direction of the thin film relative to the area of the non-smooth surface on which the concave grooves are located is controlled to fall within the foregoing ranges, which is beneficial to enhancing the light-trapping effect of the concave grooves, thereby further improving the comprehensive performance in terms of short-circuit current density and power conversion efficiency. When the proportion of the concave grooves reaches a particular degree, the non-smooth surface may exhibit a wrinkled form. In this case, dimensions of the concave grooves and raised regions between the concave grooves in a lateral direction form a well-matched combination. The distribution of the concave grooves on the surface of the perovskite thin film is relatively uniform on the whole, so that a large amount of incident light can be absorbed and the light-trapping effect of the concave grooves can be enhanced.

Based on any appropriate implementation in the present application, in some further implementations, the concave grooves satisfy one or more of the following features:
aspect ratios of at least some of the concave grooves are greater than 1, optionally, aspect ratios of at least some of the concave grooves are greater than or equal to 2, further optionally, aspect ratios of at least some of the concave grooves are greater than or equal to 3, and still further optionally, aspect ratios of at least some of the concave grooves are greater than or equal to 5;
widths of at least some of the concave grooves are less than or equal to 1.2 µm, optionally, range from 0.5 µm to 1.2 µm, and further optionally, range from 0.6 µm to 1.1 µm;
half-height widths of at least some of the concave grooves are less than or equal to 1 µm, and optionally, range from 0.2 µm to 0.6 µm;
depths of at least some of the concave grooves are greater than or equal to 100 nm, optionally, range from 100 nm to 500 nm, and further optionally, range from 100 nm to 250 nm;
depth-to-width ratios of at least some of the concave grooves range from 0.08 to 0.5, optionally, range from 0.1 to 0.5, and further optionally, range from 0.1 to 0.3.

Based on any appropriate implementation in the present application, in some further implementations, the concave grooves satisfy one or more of the following features:
in at least some regions of the non-smooth surface, an average width of the concave grooves ranges from 0.2 µm to 1 µm, optionally, ranges from 0.5 µm to 1.2 µm, and further optionally, ranges from 0.6 µm to 1.1 µm;
in at least some regions of the non-smooth surface, an average half-height width of the concave grooves ranges from 0.1 µm to 1 µm, and optionally, ranges from 0.2 µm to 0.6 µm;
in at least some regions of the non-smooth surface, an average depth of the concave grooves ranges from 100 µm to 500 nm, and optionally, ranges from 100 nm to 250 nm; and
in at least some regions of the non-smooth surface, an average depth-to-width ratio of the concave grooves ranges from 0.08 to 0.5, optionally, ranges from 0.1 to 0.5, and further optionally, ranges from 0.1 to 0.3.

A probability that photons at concave grooves are trapped by the concave grooves can be adjusted by adjusting one or more parameters of the widths, the depths, the depth-to-width ratios, and the average values of these parameters of the concave grooves. The one or more parameters are controlled to fall within the foregoing ranges, which is beneficial to enhancing the light-trapping effect of the concave grooves, thereby further improving the comprehensive performance in terms of short-circuit current density and power conversion efficiency.

Based on any appropriate implementation in the present application, in some further implementations, in at least some regions of the non-smooth surface, an average spacing between the concave grooves ranges from 1 µm to 20 µm, and optionally, ranges from 10 µm to 20 µm.

The density of the concave grooves in the perovskite thin film can be adjusted by adjusting the average spacing between the concave grooves, thereby further adjusting a quantity of the concave grooves. The average spacing between the concave grooves is controlled to fall within the foregoing ranges, so that the light-trapping effect of the concave grooves can be exerted, thereby improving the comprehensive performance in terms of short-circuit current density and power conversion efficiency.

Based on any appropriate implementation in the present application, in some further implementations, at least some of the concave grooves have opening widths greater than bottom widths.

Optionally, based on the projection areas of the concave grooves in the vertical direction, at least 50% of the concave grooves have opening widths greater than bottom widths, and further optionally, at least 80% of the concave grooves have opening widths greater than bottom widths.

Optionally, based on the projection areas of the concave grooves in the vertical direction, at least some of the concave grooves have opening widths greater than half-height widths that are in turn greater than bottom widths, further optionally, at least 50% of the concave grooves have opening widths greater than half-height widths that are in turn greater than bottom widths, and further optionally, at least 80% of the concave grooves have opening widths greater than half-height widths that are in turn greater than bottom widths.

When the concave grooves have a cross sectional shape that is wide at the top and narrow at the bottom, in this case, the concave grooves have opening widths greater than bottom widths, which is beneficial to allowing more incident light to enter the concave grooves, and is accordingly beneficial to the absorption of incident light by the perovskite thin film, to increase the amount of light trapped by the concave grooves, thereby better improving the comprehensive performance in terms of short-circuit current density and power conversion efficiency.

Based on any appropriate implementation in the present application, in some further implementations, the concave grooves satisfy one or more of the following features:
corners exist in extension directions of at least some of the concave grooves;
at least segments of lengths in extension directions of at least some of the concave grooves are non-linear; and
intersection nodes exist between at least some of the concave grooves.

When at least some of the concave grooves have one or more of the following characteristics in the extension directions: (1) corners exist in extension directions of at least some of the concave grooves; (2) at least segments of lengths in extension directions of at least some of the concave grooves are non-linear; and (3) intersection nodes exist between at least some of the concave grooves, in this case, the concave grooves are more likely to be randomly distributed on the surface of the perovskite thin film, which in this case is beneficial to shortening the distance that photons travel from a contact interface to being trapped by the perovskite thin film, and is beneficial to improving the light trapping efficiency, thereby better improving the comprehensive performance in terms of short-circuit current density and power conversion efficiency. That different concave grooves have an intersection node means that extension directions of the different concave grooves are not parallel or not completely parallel to cause an intersection, so that the different concave grooves are in communication with each other.

Based on any appropriate implementation in the present application, in some further implementations, the perovskite thin film includes a perovskite metal halide, and halogen in the perovskite metal halide includes bromine and iodine.

Based on the compositional design of the perovskite metal halide in the perovskite thin film, bromine and iodine may be both disposed in a perovskite precursor solution. Various parameters such as dimension-related parameters (for example, the lengths, widths, depths, depth-to-width ratios, and average values of any one of the foregoing) and distribution-related parameters (for example, the average spacing, the area percentage of the concave grooves to the surface of the perovskite thin film, and the surface roughness of the perovskite thin film) of the concave grooves may be regulated by adjusting the ratio of the two elements, thereby flexibly adjusting the comprehensive enhancement of short-circuit current density and power conversion efficiency by the concave grooves.

Based on any appropriate implementation in the present application, in some further implementations, an atomic molar ratio of bromine to iodine in the perovskite metal halide ranges from (3-y):y, where 0 < y ≤ 1.2.

Optionally, 0.6 ≤ x ≤ 1.2.

Based on the compositional design of the perovskite metal halide in the perovskite thin film, an atomic molar ratio of bromine to iodine in the perovskite precursor solution may be adjusted, so that the comprehensive performance in terms of short-circuit current density and power conversion efficiency of the perovskite solar cell can be improved.

Based on any appropriate implementation in the present application, in some further implementations, a band gap of the perovskite thin film ranges from 1.4 eV to 2.0 eV, and optionally, ranges from 1.6 eV to 1.8 eV.

When the perovskite thin film has the foregoing band gap, it is beneficial to improving the power density of devices. In combination with the foregoing concave groove design, it is beneficial to achieving better comprehensive performance of devices.

Based on any appropriate implementation in the present application, in some further implementations, at least some of perovskite grains in the perovskite thin film are continuous grains, and two ends of the continuous grains in the vertical direction are located on the surfaces of two sides of the perovskite thin film, respectively.

When the perovskite grains in the perovskite thin film include continuous grains in the thickness direction (that is, in the vertical direction) of the perovskite thin film, it means that these perovskite grains continuously grow in the vertical direction, have minimal cracks in a vertical cross section of the perovskite thin film, and present as large-size grains penetrating in the vertical direction. In this case, the continuous grains penetrating the perovskite thin film in the vertical direction are beneficial to smoother and more efficient transport of carriers, and are beneficial to reducing grain boundary-induced non-radiative recombination, thereby improving the power conversion efficiency of devices.

Based on any appropriate implementation in the present application, in some further implementations, sizes of at least some of the continuous grains in a lateral direction are greater than or equal to 0.4 µm.

Optionally, sizes of at least some of the continuous grains in a lateral direction are greater than or equal to 0.6 µm, optionally, greater than or equal to 0.8 µm, and further optionally, greater than or equal to 1 µm.

Optionally, an average size of the continuous grains in the lateral direction ranges from 0.6 µm to 2 µm, and optionally, ranges from 0.6 µm to 1.2 µm.

The quantity of boundaries between the perovskite grains can be adjusted by controlling the sizes of the continuous grains in the lateral direction. When the sizes in the lateral direction are larger, the quantity of through cracks between grains is smaller, and the perovskite thin film has fewer defects and higher quality. When the sizes of the continuous grains in the lateral direction are controlled to fall within the foregoing ranges, it is beneficial to fully utilize the positive effect of the foregoing continuous grains.

Based on any appropriate implementation in the present application, in some further implementations, on a vertical cross section of the perovskite thin film, an area percentage of the continuous grains whose sizes in the lateral direction are greater than or equal to 1 µm relative to the vertical cross section is greater than or equal to 30%, optionally, greater than or equal to 40%, and further optionally, greater than or equal to 50%.

The utilization of the effect of the continuous grains can be adjusted by controlling an area percentage of large-size continuous grains in the vertical cross section of the perovskite thin film. When the area percentage of the continuous grains having particular sizes in the lateral direction relative to the vertical cross section of the perovskite thin film is controlled to fall within the foregoing ranges, the advantages of the continuous grains are more fully exerted, thereby improving carrier transport and power conversion efficiency.

According to a second aspect of the present application, a perovskite solar cell is provided, including the perovskite thin film in the first aspect of the present application. The non-smooth surface in the perovskite thin film forms a non-smooth interface with an adjacent structural layer.

Based on any appropriate implementation in the present application, in some further implementations, the perovskite solar cell includes a first electrode, a first charge transport layer, a perovskite layer, a second charge transport layer, and a second electrode that are disposed in sequence.

The perovskite layer is the perovskite thin film in the first aspect of the present application.

One of the first charge transport layer and the second charge transport layer is an electron transport layer, and the other is a hole transport layer.

At least one of the first electrode and the second electrode is a transparent electrode.

The non-smooth surface in the perovskite thin film faces away from one transparent electrode.

According to a third aspect of the present application, a method for preparing a perovskite solar cell, including the following steps: sequentially stacking a first charge transport layer, a perovskite layer, a second charge transport layer, and a second electrode on a surface of a side of a first electrode to prepare the perovskite solar cell. The perovskite layer is the perovskite thin film defined in the first aspect of the present application.

A method for stacking the perovskite layer on a side of the first charge transport layer facing away from the first electrode includes the following steps:
coating a precursor solution of the perovskite layer onto a surface of the side of the first charge transport layer facing away from the first electrode; and
performing vacuum flash evaporation on the precursor solution, and performing annealing to form the perovskite layer, where the non-smooth surface is formed on a side of the perovskite layer facing away from the first electrode.

The perovskite layer is prepared through a vacuum flash evaporation process. The foregoing concave groove structure can be formed on a surface of at least one side of the perovskite layer, thereby improving light utilization and improving the comprehensive performance in terms of short-circuit current density and power conversion efficiency of the perovskite solar cell. In addition, the formation of large-size continuous grains may also be promoted, thereby promoting carrier transport and power conversion efficiency.

Based on any appropriate implementation in the present application, in some further implementations, a solvent in the precursor solution of the perovskite layer includes N,N-dimethylformamide and dimethyl sulfoxide.

Optionally, a solvent in the precursor solution of the perovskite layer is a combination of N,N-dimethylformamide and dimethyl sulfoxide.

Optionally, a volume ratio of N,N-dimethylformamide to dimethyl sulfoxide ranges from (2 to 6):1, and further optionally, (3 to 5):1.

Based on any appropriate implementation in the present application, in some further implementations, the method for preparing a perovskite solar cell satisfy one or more of the following features:
the vacuum flash evaporation is performed under a negative pressure condition, and a pressure of the negative pressure condition is less than or equal to 100 Pa, and optionally, ranges from 50 Pa to 100 Pa;
duration of the vacuum flash evaporation ranges from 15 s to 100 s, and optionally, 20 s to 60 s;
a temperature of the vacuum flash evaporation ranges from 10°C to 40°C, and optionally, 20°C to 30°C;
the annealing is performed using a hot plate method, optionally, a hot plate ranging from 90°C to 110°C is used, and further optionally, a hot plate ranging from 95°C to 105°C is used; and
an annealing time of the annealing ranges from 5 min to 20 min, and optionally, ranges from 8 min to 12 min.

Based on any appropriate implementation in the present application, in some further implementations, a coating manner in the step of coating a precursor solution of the perovskite layer onto a surface of the side of the first charge transport layer facing away from the first electrode is spin coating.

Optionally, a spin-coating speed ranges from 2000 rpm to 6000 rpm, and optionally, ranges from 2000 rpm to 4000 rpm.

The grain size and the surface morphology of the perovskite layer are regulated as required by adjusting one or more parameters in a preparation process of the perovskite layer, so that the comprehensive performance in terms of short-circuit current density and power conversion efficiency of the perovskite solar cell can be better improved through process parameter optimization.

According to a fourth aspect of the present application, a power consuming apparatus is provided, including at least one of the perovskite thin film in the first aspect of the present application, the perovskite solar cell in the second aspect of the present application, or a perovskite solar cell prepared using the method for preparing a perovskite solar cell in the third aspect of the present application.

According to a fifth aspect of the present application, a power generation apparatus, including at least one of the perovskite thin film in the first aspect of the present application, the perovskite solar cell in the second aspect of the present application, or a perovskite solar cell prepared using the method for preparing a perovskite solar cell in the third aspect of the present application.

Details of one or more implementations and embodiments according to the present application are provided in the accompanying drawings and descriptions below. Other features, objects, and advantages of the present application will become apparent from the specification, the drawings, and the claims.

### BRIEF DESCRIPTION OF THE DRAWINGS

To better describe and describe implementations, embodiments or examples of those applications disclosed herein, refer to one or more drawings. However, the additional details or examples used to describe the drawings should not be regarded as limitations to the scopes of any one of the applications disclosed, the implementations, embodiments or examples described for the present, and the optimal modes of these applications understood for the present. In addition, in all the accompanying drawings, same parts are indicated by the same reference numerals. In the accompanying drawings:
FIG. 1 is an optical micrograph of a surface morphology of a perovskite thin film prepared by vacuum flash evaporation according to an embodiment of the present application;
FIG. 2 is a diagram of comparison between measurements of surface roughness of perovskite thin films prepared according to an embodiment and a comparative example of the present application, where vacuum flash evaporation corresponds to the embodiment, an antisolvent method corresponds to a comparative example, and a horizontal axis in FIG. 2 is a trajectory (from 0 µm to 40 µm) in a lateral direction, indicating a measurement path in the lateral direction;
FIG. 3 is a current-voltage characteristic curve of a perovskite thin film prepared by vacuum flash evaporation according to an embodiment of the present application;
FIG. 4 is a scanning electron microscopy (SEM) image of a perovskite thin film prepared by vacuum flash evaporation according to an embodiment of the present application, where (A) is a vertical cross-sectional view, and (B) is a lateral cross-sectional view;
FIG. 5 is a scanning electron microscopy (SEM) image of a perovskite thin film prepared by an antisolvent method according to a comparative example of the present application, where (A) is a vertical cross-sectional view, and (B) is a lateral cross-sectional view;
FIG. 6 is a statistical histogram of grain sizes of perovskite thin films prepared in Example (a) and Comparative Example (b) of the present application, reflecting quantities of grains of different sizes in the perovskite thin film, where a is an example in which vacuum flash evaporation is used, b is a comparative example in which an antisolvent method is used, and statistical collection is performed on quantities of grains of different grain sizes based on maximum diameters of grains of the perovskite thin films within a statistical range;
FIG. 7 is a schematic diagram of a perovskite solar cell according to an implementation of the present application, including a substrate layer, a first electrode, a first charge transport layer, a perovskite layer, a second charge transport layer, and a second electrode;
FIG. 8 is a schematic diagram of a perovskite solar cell according to an implementation of the present application; and
FIG. 9 is a schematic diagram of a power consuming apparatus using a perovskite solar cell as a power generation device according to an implementation of the present application.

Reference numerals: 100 is a perovskite solar cell; 110 is a substrate layer; 120 is a first electrode; 130 is a first charge transport layer; 140 is a perovskite layer; 150 is a second charge transport layer; 160 is a second electrode; P1 is a first etched region; P2 is a second etched region; P3 is a third etched region; and 6 is a power consuming apparatus.

### DETAILED DESCRIPTION

Some implementations and some embodiments of a perovskite thin film, a perovskite solar cell, a preparation method, a power consuming apparatus, and a power generation apparatus of the present application are described below in detail with reference to the accompanying drawings as appropriate. However, there may be situations where unnecessary detailed explanations are omitted. For example, there are situations where detailed explanations of well-known matters are omitted and repeated explanations of the same structure are actually provided. Thus, the following description does not become unnecessarily lengthy, which facilitates the easy comprehension of a person skilled in the art. In addition, the accompanying drawings and the following explanations are provided for a person skilled in the art to fully understand the present application and are not intended to limit the subject matter recorded in the claims.

The "ranges" disclosed in the present application are defined in the form of lower and upper limits, with a given range being defined by the selection of a lower limit and an upper limit defining the boundaries of the particular range. A range defined in this manner may be inclusive or exclusive of the end values, and any end value may be independently inclusive or exclusive and may be arbitrarily combined, that is, any lower limit may be combined with any upper limit to form a range. For example, if ranges of 60-120 and 80-110 are listed for a particular parameter, it is to be understood that ranges of 60-110 and 80-120 are also expected. Additionally, if the minimum range values 1 and 2 and the maximum range values 3, 4 and 5 are listed, the following ranges are all contemplated: 1-3, 1-4, 1-5, 2- 3, 2-4 and 2-5. In the present application, unless otherwise specified, the numerical range "a to b" represents an abbreviated representation of any combination of real numbers between a and b, where a and b are both real numbers. For example, the numerical range "0-5" means that all real numbers between 0-5 are listed herein, and "0-5" is merely an abbreviated representation of the combination of these numbers. In addition, when a parameter is expressed as an integer ≥ 2, it is equivalent to listing that the parameter is, for example, an integer of 2, 3, 4, 5, 6, 7, 8, 9, 10, 11, 12, or the like. For example, when a parameter is expressed as an integer selected from "2-10", it is equivalent to lists integers 2, 3, 4, 5, 6, 7, 8, 9, and 10.

The terms "plurality", "multiple", "several", and the like in the present application mean greater than or equal to 2 in number, unless otherwise limited. For example, "one or more" means one or more than or equal to two. It may be understood that "any plurality of" items refers to any appropriate combination of multiple items, that is, "any plurality of" items may be combined in a manner that does not conflict with each other and that can implement the present application.

Unless otherwise specially specified, all the embodiments and optional embodiments of the present application can be combined with each other to form new technical solutions.

Reference herein to an "embodiment" means that a specific feature, structure, or characteristic described in connection with the embodiment can be included in at least one embodiment or implementation of the present application. The phrase shown in various locations in the specification may not necessarily refer to a same embodiment, and is not an independent or alternative embodiment exclusive from another embodiment. It shall be explicitly and implicitly understood by a person skilled in the art that the embodiments described herein may be combined with other embodiments. An "implementation" mentioned in this specification has a similar understanding.

A person skilled in the art may understand that in the method of each implementation or embodiment the order in which the steps are written does not imply a strict order of execution to cause any limitation to the implementation process. The detailed order of execution of the steps should be determined by their functions and possible internal logic. Unless otherwise specially specified, all the steps in the present application can be performed in the order described or in any other order, and preferably in the order described. For example, the phrase "the method M includes step (a) and step (b)" means that the method M may include step (a) and step (b) performed sequentially, or may include step (b) and step (a) performed sequentially. For example, the phrase "the method M may further include step (c)" means that step (c) may be added to the method M in any order. For example, the method M may include step (a), step (b), and step (c), or may include step (a), step (c), and step (b), or may include step (c), step (a), and step (b).

In the present application, an open technical feature or technical solution described by using words such as "contain", "include", and "comprise" does not exclude additional members other than the listed members, and may be considered as providing a closed feature or solution consisting of the listed members, and further providing an open feature or solution containing additional members other than the listed members, if no other descriptions are provided. For example, A includes a1, a2, and a3, and unless otherwise specified, may further include other members, or may not include additional members. It may be considered that a feature or solution of "A consists of a1, a2, and a3" or "A is selected from a1, a2, and a3" is provided, and a feature or solution of "A not only includes a1, a2, and a3, but also includes other members" is provided.

In the present application, unless otherwise specified, A (for example, B) indicates that B is a non-limiting example of A. It may be understood that A is not limited to B.

In the present application, "optionally", "optional", and "option" denote that a feature may be present or absent, that is, either of the two parallel options of being "present" or "absent" may be selected. If there are multiple "optional" in one technical solution, unless otherwise specified and there are no contradictions or mutual constraints, each "optional" is independent. Unless otherwise specified, for descriptions such as "optionally include" and "optionally comprise" in the present application, for example, "optionally include" indicates "may include or not include".

In the present application, unless otherwise specified, a feature or scheme corresponding to "and/or" includes any one of two or more relevant listed items, and also includes any and all combinations of the relevant listed items. The any and all combinations include combinations of any two relevant listed items, any more relevant listed items, or all relevant listed items. For example, "A and/or B" means the group consisting of A, B, and a "combination of A and B". "Including A and/or B" may mean "including A, including B, and including A and B", and may also mean "including A, including B, or including A and B", which can be properly understood according to the statement.

The "combination thereof", "any combination thereof", "any combination manner thereof", and the like used in this specification include all appropriate combination manners of any two or more of the listed items.

In this specification, "appropriate" in "an appropriate combination manner", "an appropriate manner", "any appropriate manner", and the like are subject to technical solutions capable of implementing the present application.

In this specification, "preferred" and "better" are merely intended to describe implementations or embodiments with better effects, and should not be understood as a limitation on the scope of protection of the present application. If there are multiple "preferred" in one technical solution, unless otherwise specified and there are no contradictions or mutual constraints, each "preferred" is independent.

In the present application, "further", "still further", "particularly", "for example", and "such as" are used for descriptive purposes and indicate differences in content, but should not be understood as limitations on the scope of protection of the present application.

In the present application, in the "first aspect", "second aspect", "third aspect", "fourth aspect", and the like, the terms "first", "second", "third", "fourth", and the like are only used for descriptive purposes, and cannot be understood as indicating or implying relative importance or quantity, nor implicitly indicating the importance or quantity of the indicated technical features. Moreover, the "first", "second", "third", "fourth", and the like are merely used for the purpose of non-exhaustive description, and should not be understood as constituting a closed limitation on the quantity.

In the present application, the term "room temperature" generally refers to 4°C to 35°C, and may refer to 20°C±5°C. In some embodiments of the present application, the room temperature refers to 20°C to 30°C.

In the present application, a "value" encompasses the precise value and its reasonable approximations. The definition of "value" applies both to discrete numerical points and to the endpoints of a numerical range. Unless otherwise specified, for any value or numerical range in the present application, it should be understood that the value encompasses its reasonable approximations and the numerical range encompasses reasonable approximations of both endpoints. A person skilled in the art may understand that acceptable fluctuation ranges of the relevant approximations fall within the definition of the value or numerical range. In the present application, unless otherwise specified, "N1" may reasonably be understood as "approximately N1", and "N1 to N2" may reasonably be understood as "approximately N1 to approximately N2". N1 and N2 are distinct values. For instance, in some cases, it is reasonable to include approximate values within the range of approximations in the scope defined by the numerical range due to one or more factors such as reasonably acceptable deviations in the art or the control precision of instruments. For example, a "temperature of 20°C to 30°C" may be understood as "approximately 20°C to approximately 30°C". Furthermore, taking an endpoint of "20°C" with an approximation of ±1°C as an example, approximate values such as 19°C and 19.5°C within the approximation range corresponding to "approximately 20°C" should also be included within the range indicated by "20°C to 30°C". As a non-limiting example, a percentage content of "10%" may reasonably be understood as "approximately 10%". As another non-limiting example, a percentage content of "2% to 10%" may reasonably be understood as "approximately 2% to approximately 10%". As yet another non-limiting example, a percentage content of "0%" includes at least "none" and may also include situations "below the detection limit".

In the present application, unless otherwise specified, "approximation" encompasses both the precise value and approximate values within a reasonable fluctuation range based on the precise value. The reasonable fluctuation range may vary depending on the type and magnitude of the precise value.

In the present application, with respect to the unit of a data range, if only the right end point is followed by the unit, it means that the units of the left end point and the right end point are the same. For example, 3 to 5 h and 3-5 h both indicate that the units of the left end point "3" and the right end point "5" are both h (hour), and have the same meaning as 3 h to 5 h. The aforementioned way of understanding applies not only to units of time but also to the description of units for parameters such as temperature, dimensions, and band gaps.

The weight of relevant components mentioned in the specification of the embodiments of the present application may not only refer to the content of each component, but also represent the weight ratio relationship between the components. Therefore, the contents of relevant components scaled up or down according to the specification of the embodiments of the present application are embraced within the scope disclosed in the specification of the embodiments of the present application. Further, the mass described in the specification of the embodiments of the present application may be a mass unit known in the chemical domain, for example, microgram (µg), milligram (mg), gram (g), kilogram (kg) and the like.

In the present application, "greater than or equal to" may be equivalently expressed as "≥"; "less than or equal to" may be equivalently expressed as "≤"; "greater than" may be equivalently expressed as ">"; and "less than" may be equivalently expressed as "<". In the present application, unless otherwise specified, "greater than or equal to" and "≥" shall be understood as encompassing both the solution of being "greater than" and the solution of being "equal to". In the present application, unless otherwise specified, the expressions "less than or equal to" and "≤" shall be understood as encompassing both the solution of being "less than" and the solution of being "equal to".

In the present application, unless otherwise specified, with respect to parameter units, the temperature unit "°C" denotes "degrees Celsius", the time unit "min" denotes "minutes", the time unit "s" denotes "seconds", the length unit "mm" denotes "millimeters", "µm" denotes "micrometers", "nm" denotes "nanometers", the volume unit "µL" denotes "microliters", the area unit "mm²" denotes "square millimeters", the pressure unit "Pa" denotes "pascals", the short-circuit current density unit "mA/cm²" denotes "milliamperes per square centimeter", the rotational speed unit "rpm" denotes "revolutions per minute", and the energy unit "eV" denotes "electronvolts".

In the present application, exemplary descriptions such as "in some implementations (or embodiments)" and "in one implementation (or embodiment)" may encompass, but are not limited to, the following meaning: these solutions may be combined with other solutions in an appropriate manner to form new technical solutions.

In this specification, unless otherwise specified, "alkyl" refers to a monovalent residue generated by removing one hydrogen atom from a saturated hydrocarbon containing primary (normal) carbon atoms, secondary carbon atoms, tertiary carbon atoms, quaternary carbon atoms, or a combination thereof. Phrases containing this term, such as "C₁-₉ alkyl", denote an alkyl group containing 1 to 9 carbon atoms. Each occurrence may independently be a C₁ alkyl, C₂ alkyl, C₃ alkyl, C₄ alkyl, C₅ alkyl, C₆ alkyl, C₇ alkyl, C₈ alkyl, or C₉ alkyl group. Appropriate examples include, but are not limited to, methyl (Me, -CH₃), ethyl (Et, -CH₂CH₃), 1-propyl (n-Pr, n-propyl, -CH₂CH₂CH₃), 2-propyl (i-Pr, i-propyl, -CH(CH₃)₂), 1-butyl (n-Bu, n-butyl, -CH₂CH₂CH₂CH₃), 2-methyl-1-propyl (i-Bu, i-butyl, -CH₂CH(CH₃)₂), 2-butyl (s-Bu, s-butyl, -CH(CH₃)CH₂CH₃), 2-methyl-2-propyl (t-Bu, t-butyl, -C(CH₃)₃), 1-amyl (n-amyl, -CH₂CH₂CH₂CH₂CH₃), 2-amyl (-CH(CH₃)CH₂CH₂CH₃), 3-amyl (-CH(CH₂CH₃)₂), 2-methyl-2-butyl (-C(CH₃)₂CH₂CH₃), 3-methyl-2-butyl (-CH(CH₃)CH(CH₃)₂), 3-methyl-1-butyl (-CH₂CH₂CH(CH₃)₂), 2-methyl-1-butyl (-CH₂CH(CH₃)CH₂CH₃), 1-hexyl (-CH₂CH₂CH₂CH₂CH₂CH₃), 2-hexyl (-CH(CH₃)CH₂CH₂CH₂CH₃), 3-hexyl (-CH(CH₂CH₃)(CH₂CH₂CH₃)), 2-methyl-2-amyl (-C(CH₃)₂CH₂CH₂CH₃), 3-methyl-2-amyl (-CH(CH₃)CH(CH₃)CH₂CH₃), 4-methyl-2-amyl (-CH(CH₃)CH₂CH(CH₃)₂), 3-methyl-3-amyl (-C(CH₃)(CH₂CH₃)₂), 2-methyl-3-amyl (-CH(CH₂CH₃)CH(CH₃)₂), 2,3-dimethyl-2-butyl (-C(CH₃)₂CH(CH₃)₂), 3,3-dimethyl-2-butyl (-CH(CH₃)C(CH₃)₃, and capryl (-(CH₂)₇CH₃).

In this specification, unless otherwise specified, "aryl" refers to an aromatic hydrocarbon group derived by removing one hydrogen atom from an aromatic cyclic hydrocarbon compound, i.e., forming a monovalent attachment site directly on the ring, and may be a monocyclic aryl, fused-ring aryl, or polycyclic aryl group. For polycyclic ring systems, at least one ring is an aromatic ring system. For example, "C₆ to C₁₀ aryl" refers to an aryl group containing 6 to 10 carbon atoms. Each occurrence may independently be a C₆ aryl, C₈ aryl, C₉ aryl, or C₁₀ aryl group. As another example, "C₆ to C₂₀ aryl" refers to an aryl group containing 6 to 20 carbon atoms. Each occurrence may independently be, but is not limited to, C₆ aryl (for example, phenyl), C₆ aryl aryl (for example, benzocyclobutenyl), C₈ aryl (for example, benzocyclobutenyl), C₉ aryl (for example, indenyl), C₁₀ aryl (for example, naphthyl), C₁₂ aryl (for example, acenaphthylenyl, biphenylyl), C₁₃ aryl (for example, fluorenyl), C₁₄ aryl (for example, anthryl, phenanthryl), C₁₈ aryl (for example, triphenylenyl), or C₂₀ aryl (for example, perylenyl). Examples of appropriate aromatic cyclic hydrocarbon compounds include, but are not limited to, benzene, benzocyclobutene, biphenyl, indene, naphthalene, acenaphthylene, fluorene, anthracene, phenanthrene, triphenylene, perylene, and derivatives thereof.

A common method for preparing a conventional perovskite thin film is an antisolvent method, and is usually used for preparing a perovskite thin film in a small-area wide-band gap perovskite solar cell. A preparation process using the antisolvent method involves an antisolvent addition process, and is easily affected by human factors of an operator.

When a special regulation strategy is not used, surfaces of two sides of the perovskite thin film are usually smooth surfaces, and some incident light penetrates the perovskite thin film without being used. Consequently, the light utilization is poor.

According to **a first aspect**, the present application provides a perovskite thin film. A surface of at least one side of the perovskite thin film is a non-smooth surface including concave grooves. The perovskite thin film may be used to provide a perovskite layer in a perovskite solar cell, and can improve the comprehensive performance in terms of short-circuit current density and power conversion efficiency.

In the present application, unless otherwise specified, the "perovskite thin film" refers to a thin film including a perovskite material, and may be used as a light-absorbing layer in a solar cell. In this case, the solar cell may be recorded as a perovskite solar cell, and a corresponding light-absorbing layer may be recorded as a perovskite layer. Usually, the perovskite material includes a perovskite metal halide.

In the present application, unless otherwise specified, a thickness direction of the perovskite thin film is recorded as a "vertical direction". In the thickness direction of the thin film, the perovskite thin film has two surfaces facing away from each other, which may be respectively recorded as a first surface and a second surface. A direction orthogonal to the vertical direction is recorded as a "lateral direction".

In the present application, unless otherwise specified, the "non-smooth surface" of the perovskite thin film means that a non-smooth region exists on the surface of the thin film, and the surface of the thin film in the non-smooth region exhibits undulations in the thickness direction of the thin film, so that the surface of the thin film has particular roughness. In the present application, height differences that cause surface roughness in the non-smooth surface are usually greater than or equal to 100 nm (≥ 100 nm). For a non-smooth surface of the perovskite thin film, a vector direction pointing from the inside of the thin film to the non-smooth surface in the vertical direction is recorded as a "first direction".

In the present application, the "concave groove" on the surface of the perovskite thin film refers to a recess having a particular depth in the thickness direction of the thin film. The concave groove has a particular aspect ratio in the lateral direction to form a strip-shaped contour, and a length direction of the strip-shaped contour may be recorded as an extension direction of the concave groove. An independent concave groove is not in communication with any other concave groove at a position other than two endpoints within a range of an extension length of the concave groove. Any endpoint may independently be a closed endpoint, or may be in communication with another concave groove through an intersection node. In the present application, an "intersection node" between different concave grooves refers to a node formed by intersection between the different concave grooves in the extension direction. At the intersection node, the different concave grooves that intersect are in communication with each other. A trajectory shape in the extension direction of the concave groove is not particularly limited, and may be a straight line segment, or may be an irregular line segment.

The "extension direction of the concave groove" refers to an extension direction of the concave groove in the lateral direction. In the lateral direction, the extension direction of the concave groove may be obtained in the following manner: acquiring a peripheral extension contour of the concave groove on the surface of the perovskite thin film, and sequentially connecting width centers of the peripheral extension contour at positions of different lengths, so that an obtained contour width center connection line may be used for representing the extension direction of the concave groove, and the contour width center connection line may be recorded as an "extension line of the concave groove". In an extension contour of the concave groove located on the surface of the thin film, a length of the contour width center connection line of the concave groove may be recorded as a "length of the concave groove".

On the non-smooth surface provided with the concave grooves, the "average spacing between the concave grooves" may be obtained by statistically analyzing an average distance between extension lines, for example, may be obtained by performing acquisition at different positions and statistically averaging distances between the extension lines at different acquisition positions. An average spacing between the concave grooves in a selected region may be estimated using the following formula: A1/L1. A1 is an area of a selected non-smooth region, and L1 is a sum of lengths of extension lines of the concave grooves in the selected non-smooth region.

"The vertical cross section of the concave groove" is a cross section that is orthogonal to the extension line of the concave groove and that is parallel to the thickness direction of the thin film, a contour line of the vertical cross section is an open shape line that is open above and that is sunk downward, and a position of the contour line of the vertical cross section close to an outer side of the thin film is recorded as "above". A line connecting two upper endpoints of the contour line of the vertical cross section is recorded as an "opening connection line". A length of the opening connection line is recorded as an "opening width of the concave groove" or a "width of the concave groove". A position of a vertical contour line farthest away from the opening connection line is recorded as a "bottom of the concave groove", a straight line parallel to the opening connection line is drawn at a position of the bottom, and a length of a line segment intercepted by the contour line of the vertical cross section of the straight line is recorded as a "bottom width of the concave groove". Vertical distances between points on the contour line of the vertical cross section and the opening connection line correspond to depths of the concave groove at different contour positions. The largest vertical distance is recorded as a "depth of the concave groove". A straight line parallel to the opening connection line is drawn at a midpoint (that is, a half height) of the largest depth, and a length of a line segment of the straight line intercepted by the contour line of the vertical cross section is recorded as a "half-height width of the concave groove".

A ratio of the length of the concave groove to the width of the concave groove is recorded as an "aspect ratio of the concave groove". Unless otherwise specified, the aspect ratio of the concave groove is greater than 1.

A ratio of the depth of the concave groove to the width of the concave groove is recorded as a "depth-to-width ratio of the concave groove".

In the present application, shape parameters of the concave grooves on the surface of the perovskite thin film may be measured and analyzed using the following method, including, but not limited to:
(1) A morphological image or surface roughness curve of the surface of the perovskite thin film may be obtained using scanning electron microscopy (SEM), optical micrography, stylus profilometry, or another method, and the following information and/or parameters may be measured and analyzed by combining image analysis software such as Image-J, and include, but are not limited to, the extension contour of the concave groove on the surface of the perovskite thin film, the extension line of the concave groove, the extension direction of the concave groove, the length of the concave groove, the average spacing between the concave grooves, and the area of the non-smooth region.
(2) A vertical cross-sectional view of the perovskite thin film is obtained using scanning electron microscopy (SEM), optical micrography, or another method, and the following information and/or parameters may be measured and analyzed by combining image analysis software such as Image-J: the vertical cross section of the concave groove, the contour line of the vertical cross section, the opening connection line, the opening width of the concave groove, the width of the concave groove, the bottom width of the concave groove, the depth of the concave groove, the half-height width of the concave groove, the aspect ratio of the concave groove, the depth-to-width ratio of the concave groove, and the like.
(3) Average values: The average values such as an average width of the concave grooves, an average half-height width, an average depth of the concave grooves, an average depth-to-width ratio of the concave grooves, an average length of the concave grooves, and an average aspect ratio of the concave grooves may be obtained by acquiring corresponding parameter values at a plurality of positions and performing a simple arithmetic mean operation. The quantity of acquisition positions may be properly selected based on a differentiation level of shapes and dimensions of the concave grooves. For example, a minimum data acquisition amount may be determined by controlling a standard deviation of an average value to be less than or equal to (≤) 10% of the average value. Taking obtaining the average width of the concave grooves as a non-limiting example, width values of the concave grooves at an appropriate quantity of (for example, 20) positions may be acquired, and an average value obtained by performing a simple arithmetic mean operation may be used as the "average width of the concave grooves".

A to-be-measured sample of the perovskite thin film may be obtained using the method in the following embodiment. Taking SEM observation as an example, a thin-film assembly in which a perovskite layer has been deposited on a hole transport layer and in which an electron transport layer has not been deposited is used as the to-be-measured sample. Measurement and analysis may be performed in the vertical direction and the lateral direction: (1) An observed surface is a surface of a side of the perovskite layer. (2) A diamond scribe is used to cleave the sample of the perovskite thin film in the vertical direction, and SEM measurement is performed with a vertical cross section facing upward. (3) A cryo-focused ion beam (FIB) is used for slicing in the vertical direction, an obtained cross section is the vertical cross section, and the cross section is subjected to SEM morphological observation.

In some implementations, a perovskite thin film is provided. A thickness direction of the perovskite thin film is recorded as a vertical direction. The perovskite thin film has two surfaces facing away from each other in the vertical direction. At least one surface is a non-smooth surface. The non-smooth surface is provided with a plurality of concave grooves. At least a portion of a side surface of each of the concave grooves forms an inclination angle relative to the vertical direction.

It may be understood that because of the presence of the concave grooves, a non-smooth region exists on the non-smooth surface.

In the present application, unless otherwise specified, "at least a portion of a side surface of each of the concave grooves forms an inclination angle relative to the vertical direction" indicates that at least some of the concave grooves satisfy: widths at at least some depth positions are different.

A surface of at least one side of the perovskite thin film is disposed as the non-smooth surface. The concave grooves are provided in at least some regions of the non-smooth surface. In this case, trench-shaped elongated concave portions are introduced into the surface of the thin film, so that at least a portion of the side surface of each of the concave grooves forms the inclination angle relative to the vertical direction. Through the reflection of incident light by the side surfaces of the concave portions, chances of contact between photons and the perovskite thin film at interfaces of the concave grooves can be increased, and a light re-incidence ratio can be improved, thereby increasing a total amount of light entering the perovskite thin film and enhancing the utilization of incident light, so that the comprehensive performance in terms of short-circuit current density and power conversion efficiency of the perovskite solar cell can be improved.

Based on any appropriate implementation in the present application, in some further implementations, surface roughness of non-smooth regions formed by at least some of the concave grooves is greater than or equal to 100 nm, and optionally, surface roughness of non-smooth regions formed by at least some of the concave grooves ranges from 100 nm to 250 nm. Non-limitingly, the surface roughness of non-smooth regions formed by at least some of the concave grooves may alternatively be selected from any one of the following values, or greater than or equal to any one of the following values (optionally, less than or equal to 250 nm), or selected from an interval formed by any two of the following values: 100 nm, 110 nm, 120 nm, 130 nm, 140 nm, 150 nm, 160 nm, 180 nm, 200 nm, 210 nm, 220 nm, 240 nm, 250 nm, and the like.

In the present application, unless otherwise specified, "surface roughness" refers to the surface unevenness formed by the alternating arrangement of micro- and nano-scale convex and concave portions on the surface. Smaller surface roughness indicates a smoother surface, while larger surface roughness indicates a more uneven surface. In a perovskite thin film, larger surface roughness caused by concave grooves indicates a more uneven surface of the perovskite thin film.

In the present application, unless otherwise specified, the "surface roughness" of the perovskite thin film may be represented by a distance between the highest position and the lowest position of a concave groove in the vertical direction. Usually, a concave portion between two nearest neighboring projections whose height difference between the highest position and the lowest position is greater than or equal to 100 nm is recorded as a "concave groove", and a fluctuation less than 100 nm is considered as a morphological change within the concave groove. Unless otherwise specified, the "surface roughness" of a specified region is equal to the average depth of concave grooves in the specified region in value.

A method for measuring the surface roughness of the selected non-smooth region may be measurement using a stylus profilometer, but is not limited thereto. The stylus profilometer may be a probe-type profilometer. Refer to a measurement method in the following embodiment part. A statistical analysis is performed on the dimensions of the concave grooves based on a surface roughness curve obtained through measurement.

In some implementations, the surface roughness is measured using stylus profilometry.

The shapes and dimensions (for example, lengths, widths, depths, aspect ratios, length-to-depth ratios, and depth-to-width ratios) of the concave grooves and a distribution quantity and a distribution manner of the concave grooves on the surface of the perovskite thin film may affect the surface roughness of the perovskite thin film. The concave groove can be controlled to have a more appropriate morphology by controlling the surface roughness in the non-smooth regions in the non-smooth surface to fall within the foregoing ranges, which is beneficial to enhancing the light-trapping effect of the concave grooves, thereby further improving the comprehensive performance in terms of short-circuit current density and power conversion efficiency.

Based on any appropriate implementation in the present application, in some further implementations, on the non-smooth surface, a percentage (which may be recorded as R1) of a sum of projection areas of the concave grooves in the vertical direction relative to a projection area of the non-smooth surface in the vertical direction is greater than or equal to 10%, optionally greater than or equal to 30%, and further optionally greater than or equal to 50%. Non-limitingly, on the non-smooth surface, the percentage of the sum of the projection areas of the concave grooves in the vertical direction relative to the projection area of the non-smooth surface in the vertical direction may alternatively be selected from any one of the following percentages, or greater than or equal to any one of the following percentages, or selected from an interval formed by any two of the following percentages: 10%, 15%, 20%, 25%, 30%, 35%, 40%, 45%, 50%, 60%, 70%, and 80%. Non-limitingly, R1 may alternatively be selected from an interval formed by any one of the foregoing percentages and 100%. Non-limitingly, R1 may alternatively be selected from any appropriate range of the following ranges: 10% to 100%, 30% to 100%, 40% to 100%, 50% to 100%, 60% to 100%, 30% to 90%, 40% to 90%, 50% to 90%, 60% to 90%, 30% to 80%, 40% to 80%, 50% to 80%, 60% to 80%, 30% to 70%, 40% to 70%, 50% to 70%, 60% to 70%, 30% to 60%, 40% to 60%, 50% to 60%, and the like. Non-limitingly, R1 may alternatively be selected from any one of the following percentages, or greater than or equal to any one of the following percentages, or selected from an interval formed by any two of the following percentages, or selected from an interval formed by any one of the following percentages and 100%: 10%, 15%, 20%, 25%, 30%, 35%, 40%, 45%, 50%, 60%, 70%, 80%, 90%, and the like.

The "percentage of the sum of the projection areas of the concave grooves in the vertical direction relative to the projection area of the non-smooth surface in the vertical direction" may reflect a proportion of the concave grooves to the non-smooth surface.

The amount of light trapped by the concave grooves may be adjusted by adjusting the percentage of the sum of the projection areas of the concave grooves in the vertical direction relative to the projection area of the non-smooth surface in the vertical direction. "A percentage of a sum of projection areas of the concave grooves in the thickness direction of the thin film relative to the projection area of the non-smooth surface on which the concave grooves are located in the vertical direction" is controlled to fall within the foregoing ranges, which is beneficial to enhancing the light-trapping effect of the concave grooves, thereby further improving the comprehensive performance in terms of short-circuit current density and power conversion efficiency. When the proportion of the concave grooves reaches a particular degree, the non-smooth surface may exhibit a wrinkled form. In this case, dimensions of the concave grooves and raised regions between the concave grooves in a lateral direction form a well-matched combination. The distribution of the concave grooves on the surface of the perovskite thin film is relatively uniform on the whole, so that a large amount of incident light can be absorbed and the light-trapping effect of the concave grooves can be enhanced.

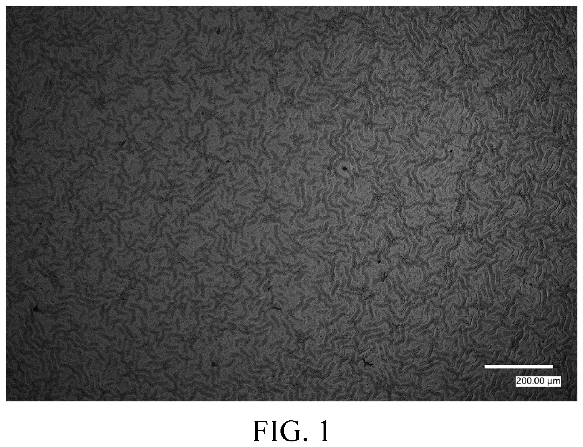

Based on any appropriate implementation in the present application, in some further implementations, aspect ratios of at least some of the concave grooves are greater than 1, optionally, aspect ratios of at least some of the concave grooves are greater than or equal to 2, further optionally, aspect ratios of at least some of the concave grooves are greater than or equal to 3, and still further optionally, aspect ratios of at least some of the concave grooves are greater than or equal to 5. Non-limitingly, the aspect ratios of at least some of the concave grooves may alternatively be any one of the following values, or greater than or equal to any one of the following values, or selected from an interval formed by any two of the following values: 1.5, 2, 2.5, 3, 3.5, 4, 4.5, 5, 5.5, 6, 6.5, 7, 7.5, 8, and the like. Refer to FIG. 1. Non-limitingly, the aspect ratios of at least some of the concave grooves fall within any appropriate range as follows: 1.5 to 8, 2 to 8, 2.5 to 8, 3 to 8, 4 to 8, 5 to 8, 1.5 to 7.5, 2 to 7.5, 2.5 to 7.5, 3 to 7.5, 4 to 7.5, 5 to 7.5, 1.5 to 6, 2 to 6, 2.5 to 6, 3 to 6, 4 to 6, 5 to 6, and the like.

FIG. 1 is an optical micrograph of a surface morphology of a perovskite thin film according to an embodiment of the present application. Concave grooves are relatively uniformly distributed on the surface of the perovskite thin film as a whole, and dimensions of the concave grooves and raised regions between the concave grooves in a lateral direction form a well-matched combination, exhibiting a wrinkled morphology on the whole.

A proportion of the projection areas of the concave grooves in the vertical direction to the projection area of the perovskite thin film in the vertical direction may be adjusted by comprehensively adjusting the widths and the length s of the concave grooves. A higher proportion indicates a more prominent effect of the concave grooves on the comprehensive improvement of the overall current level and the power conversion efficiency. It may be understood that the value of the foregoing R1 may be adjusted by comprehensively adjusting the widths and the lengths of the concave groove. The value of R1 is the percentage of the sum of the projection areas of the concave grooves in the vertical direction relative to the projection area of the non-smooth surface in the vertical direction.

Based on any appropriate implementation in the present application, in some further implementations, widths of at least some of the concave grooves may be less than or equal to 1.2 µm, optionally, range from 0.5 µm to 1.2 µm, and further optionally, range from 0.6 µm to 1.1 µm. Non-limitingly, the widths of at least some of the concave grooves may alternatively be selected from any one of the following values, or less than or equal to any one of the following values, or selected from an interval formed by any two of the following values: 0.5 µm, 0.6 µm, 0.7 µm, 0.8 µm, 0.9 µm, 1 µm, 1.1 µm, 1.15 µm, 1.2 µm, and the like.

Based on any appropriate implementation in the present application, in some further implementations, half-height widths of at least some of the concave grooves may be less than or equal to 1 µm, and optionally, range from 0.2 µm to 0.6 µm. Non-limitingly, the half-height widths of at least some of the concave grooves may alternatively be selected from any one of the following values, or less than or equal to any one of the following values, or selected from an interval formed by any two of the following values: 0.2 µm, 0.3 µm, 0.4 µm, 0.5 µm, 0.6 µm, and 0.7 µm. The half-height widths of at least some of the concave grooves may alternatively be selected from an appropriate range of the following ranges: 0.1 µm to 1 µm, 0.2 µm to 1 µm, 0.2 µm to 0.7 µm, and the like.

Based on any appropriate implementation in the present application, in some further implementations, depths of at least some of the concave grooves may be greater than or equal to 100 nm, optionally, range from 100 nm to 500 nm, and further optionally, range from 100 nm to 250 nm. The depths of at least some of the concave grooves may alternatively be selected from any one of the following values, or greater than or equal to any one of the following values (optionally, less than or equal to 500 nm), or selected from an interval formed by any two of the following values: 100 nm, 110 nm, 120 nm, 130 nm, 140 nm, 150 nm, 160 nm, 180 nm, 200 nm, 210 nm, 220 nm, 240 nm, 250 nm, 300 nm, 350 nm, 400 nm, 450 nm, 500 nm, and the like.

Based on any appropriate implementation in the present application, in some further implementations, depth-to-width ratios of at least some of the concave grooves may range from 0.08 to 0.5, optionally, range from 0.1 to 0.5, and further optionally, range from 0.1 to 0.3. Non-limitingly, the depth-to-width ratios of at least some of the concave grooves may alternatively be selected from any one of the following values or selected from an interval formed by any two of the following values: 0.08, 0.1, 0.15, 0.2, 0.22, 0.24, 0.25, 0.26, 0.275, 0.28, 0.30, 0.32, 0.35, 0.36, 0.38, 0.40, 0.42, 0.45, 0.46, 0.48, and 0.50.

Based on any appropriate implementation in the present application, in some further implementations, an average width of the concave grooves may range from 0.2 µm to 1 µm, optionally, range from 0.5 µm to 1.2 µm, and further optionally, range from 0.6 µm to 1.1 µm. Non-limitingly, the average width of the concave grooves may alternatively be selected from any one of the following values, or less than or equal to any one of the following values, or selected from an interval formed by any two of the following values: 0.2 µm, 0.3 µm, 0.4 µm, 0.5 µm, 0.6 µm, 0.7 µm, 0.8 µm, 0.9 µm, 1 µm, 1.1 µm, 1.15 µm, 1.2 µm, and the like. In some implementations, an average width of at least some of the concave grooves may range from 0.6 µm to 1.15 µm.

Based on any appropriate implementation in the present application, in some further implementations, an average half-height width of the concave grooves may be less than or equal to 1 µm, and optionally, range from 0.2 µm to 0.3 µm. Non-limitingly, the average half-height width of the concave grooves may alternatively be selected from any one of the following values, or less than or equal to any one of the following values, or selected from an interval formed by any two of the following values: 0.2 µm, 0.3 µm, 0.4 µm, 0.5 µm, 0.6 µm, and 0.7 µm. The average half-height width of the concave grooves may alternatively be selected from an appropriate range of the following ranges: 0.1 µm to 1 µm, 0.2 µm to 1 µm, 0.2 µm to 0.7 µm, and the like.

Based on any appropriate implementation in the present application, in some further implementations, an average depth of the concave grooves may range from 100 nm to 500 nm, and optionally, range from 100 nm to 250 nm. Non-limitingly, the average depth of the concave grooves may alternatively be selected from any one of the following values or selected from an interval formed by any two of the following values: 100 nm, 110 nm, 120 nm, 130 nm, 140 nm, 150 nm, 160 nm, 180 nm, 200 nm, 210 nm, 220 nm, 240 nm, 250 nm, 300 nm, 350 nm, 400 nm, 450 nm, 500 nm, and the like.

Based on any appropriate implementation in the present application, in some further implementations, an average depth-to-width ratio of the concave grooves may range from 0.08 to 0.5, optionally, range from 0.1 to 0.5, and further optionally, range from 0.1 to 0.3. Non-limitingly, the average depth-to-width ratio of the concave grooves may alternatively be selected from any one of the following values or selected from an interval formed by any two of the following values: 0.08, 0.1, 0.15, 0.2, 0.22, 0.24, 0.25, 0.26, 0.275, 0.28, 0.30, 0.32, 0.35, 0.36, 0.38, 0.40, 0.42, 0.45, 0.46, 0.48, and 0.50.

The widths, the depths, and the depth-to-width ratios of the concave grooves and the average values of these parameters may be combined in any appropriate manner.

Based on any appropriate implementation in the present application, in some further implementations, the concave grooves satisfy one or more of the following features (any numerical parameter in the following features may alternatively be selected from any appropriate value or range in the context):
aspect ratios of at least some of the concave grooves are greater than 1, optionally, aspect ratios of at least some of the concave grooves are greater than or equal to 2, further optionally, aspect ratios of at least some of the concave grooves are greater than or equal to 3, and still further optionally, aspect ratios of at least some of the concave grooves are greater than or equal to 5;
widths of at least some of the concave grooves are less than or equal to 1.2 µm, optionally, range from 0.5 µm to 1.2 µm, and further optionally, range from 0.6 µm to 1.1 µm;
half-height widths of at least some of the concave grooves are less than or equal to 1 µm, and optionally, range from 0.2 µm to 0.6 µm;
depths of at least some of the concave grooves are greater than or equal to 100 nm, optionally, range from 100 nm to 500 nm, and further optionally, range from 100 nm to 250 nm;
depth-to-width ratios of at least some of the concave grooves range from 0.08 to 0.5, optionally, range from 0.1 to 0.5, and further optionally, range from 0.1 to 0.3.

Based on any appropriate implementation in the present application, in some further implementations, the concave grooves satisfy one or more of the following features (any numerical parameter in the following features may alternatively be selected from any appropriate value or range in the context):
in at least some regions of the non-smooth surface, an average width of the concave grooves ranges from 0.2 µm to 1 µm, optionally, ranges from 0.5 µm to 1.2 µm, and further optionally, ranges from 0.6 µm to 1.1 µm;
in at least some regions of the non-smooth surface, an average half-height width of the concave grooves ranges from 0.1 µm to 1 µm, and optionally, ranges from 0.2 µm to 0.6 µm;
in at least some regions of the non-smooth surface, an average depth of the concave grooves ranges from 100 nm to 500 nm, and optionally, ranges from 100 nm to 250 nm; and
in at least some regions of the non-smooth surface, an average depth-to-width ratio of the concave grooves ranges from 0.08 to 0.5, optionally, ranges from 0.1 to 0.5, and further optionally, ranges from 0.1 to 0.3.

In the present application, unless otherwise specified, "at least some of the concave grooves" may be used in terms of extension lengths of the concave grooves, and may represent at least 80% of the extension lengths, or may represent 90% to 100% of the extension lengths.

In the present application, unless otherwise specified, "at least some regions" in "at least some regions of the non-smooth surface" and "at least some regions on the surface of the perovskite thin film" refers to portions of the non-smooth surface or portions of the perovskite thin film corresponding to projection area regions whose projection areas in the vertical direction are at least a particular value. "At least some regions of the non-smooth surface" may alternatively be expressed as "non-smooth surface regions corresponding to at least some projection areas in the projection area of the non-smooth surface in the vertical direction". Projection areas of at least some regions of the non-smooth surface or at least some regions on the surface of the perovskite thin film in the vertical direction are optionally greater than or equal to 0.1 mm², further optionally, greater than or equal to 0.5 mm², further optionally, greater than or equal to 0.6 mm², and is 960000 µm² in a non-limiting example.

Based on any appropriate implementation in the present application, in some further implementations, in the non-smooth surface, the concave grooves satisfy one or more of the following features (any numerical parameter in the following features may alternatively be selected from any appropriate value or range in the context):
an average width of the concave grooves ranges from 0.2 µm to 1 µm, optionally, ranges from 0.5 µm to 1.2 µm, and further optionally, ranges from 0.6 µm to 1.1 µm;
an average half-height width of the concave grooves ranges from 0.1 µm to 1 µm, and optionally, ranges from 0.2 µm to 0.6 µm;
an average depth of the concave grooves ranges from 100 nm to 500 nm, and optionally, ranges from 100 nm to 250 nm; and
an average depth-to-width ratio of the concave grooves ranges from 0.08 to 0.5, optionally, ranges from 0.1 to 0.5, and further optionally, ranges from 0.1 to 0.3.

A probability that photons at concave grooves are trapped by the concave grooves can be adjusted by adjusting one or more parameters of the widths, the depths, the depth-to-width ratios, and the average values of these parameters of the concave grooves. The foregoing one parameter is controlled to fall within the foregoing range or a plurality of parameters are controlled to fall within the foregoing ranges in an acceptable combination manner, which is beneficial to enhancing the light-trapping effect of the concave grooves, thereby further improving the comprehensive performance in terms of short-circuit current density and power conversion efficiency.

Based on any appropriate implementation in the present application, in some further implementations, in at least some regions of the non-smooth surface, an average spacing between the concave grooves ranges from 1 µm to 20 µm, and optionally, ranges from 10 µm to 20 µm. Non-limitingly, the average spacing between the concave grooves may alternatively be selected from any one of the following values or selected from an interval formed by any two of the following values: 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, and the like.

The density of the concave grooves in the perovskite thin film can be adjusted by adjusting the average spacing between the concave grooves, thereby further adjusting a quantity of the concave grooves. The average spacing between the concave grooves is controlled to fall within the foregoing ranges, so that the light-trapping effect of the concave grooves can be exerted, thereby improving the comprehensive performance in terms of short-circuit current density and power conversion efficiency.

Based on any appropriate implementation in the present application, in some further implementations, at least some of the concave grooves have opening widths greater than bottom widths. In some implementations, based on the projection areas of the concave grooves in the vertical direction, at least 50% of the concave grooves have opening widths greater than bottom widths, and further optionally, at least 80% of the concave grooves have opening widths greater than bottom widths. Non-limitingly, a percentage of a sum of projection areas of concave grooves in the vertical direction that satisfy "the concave grooves have opening widths greater than bottom widths" relative to a sum of projection areas of all the concave grooves in the vertical direction may alternatively be selected from any one of the following percentages, or greater than or equal to any one of the following percentages, or selected from an interval formed by any one of the following percentages and 100%, or selected from an interval formed by any two of the following percentages: 50%, 60%, 70%, 80%, 90%, 95%, 99%, and the like. In some implementations, 100% of the concave grooves have opening widths greater than bottom widths.

In some implementations, at least some of the concave grooves have opening widths greater than half-height widths that are in turn greater than bottom widths. In some implementations, based on the projection areas of the concave grooves in the vertical direction, at least 50% of the concave grooves have opening widths greater than half-height widths that are in turn greater than bottom widths, and further optionally, at least 80% of the concave grooves have opening widths greater than half-height widths that are in turn greater than bottom widths. Non-limitingly, a percentage of a sum of projection areas of concave grooves in the vertical direction that satisfy "the concave grooves have opening widths greater than half-height widths that are in turn greater than bottom widths" relative to a sum of projection areas of all the concave grooves in the vertical direction may alternatively be selected from any one of the following percentages, or greater than or equal to any one of the following percentages, or selected from an interval formed by any one of the following percentages and 100%, or selected from an interval formed by any two of the following percentages: 50%, 60%, 70%, 80%, 90%, 95%, 99%, and the like. In some implementations, 100% of the concave grooves have opening widths greater than half-height widths that are in turn greater than bottom widths.

In the present application, "at least 50% of the concave grooves" in "based on the projection areas of the concave grooves in the vertical direction, at least 50% of the concave grooves" means "concave grooves corresponding to at least 50% of the projection areas in the projection areas of the concave grooves in the vertical direction".

When the concave grooves have a cross sectional shape that is wide at the top and narrow at the bottom, in this case, the concave grooves have opening widths greater than bottom widths, which is beneficial to allowing more incident light to enter the concave grooves, and is accordingly beneficial to the absorption of incident light by the perovskite thin film, to increase the amount of light trapped by the concave grooves, thereby better improving the comprehensive performance in terms of short-circuit current density and power conversion efficiency.

Based on any appropriate implementation in the present application, in some further implementations, the concave grooves satisfy one or more of the following features:
corners exist in extension directions of at least some of the concave grooves;
at least segments of lengths in extension directions of at least some of the concave grooves are non-linear; and
intersection nodes exist between at least some of the concave grooves.

In the present application, the "intersection node between the concave grooves" refers to an intersection position where two concave grooves whose extension directions are not completely the same form communication.

When at least some of the concave grooves have one or more of the following characteristics in the extension directions: (1) corners exist in extension directions of at least some of the concave grooves; (2) at least segments of lengths in extension directions of at least some of the concave grooves are non-linear; and (3) intersection nodes exist between at least some of the concave grooves, in this case, the concave grooves are more likely to be randomly distributed on the surface of the perovskite thin film, which in this case is beneficial to shortening the transport distance that photons travel from a contact interface to being trapped by the perovskite thin film, and is beneficial to improving the light trapping efficiency, thereby better improving the comprehensive performance in terms of short-circuit current density and power conversion efficiency. That different concave grooves have an "intersection node" means that extension directions of the different concave grooves are not parallel or not completely parallel to cause an intersection, so that the different concave grooves are in communication with each other.

Based on any appropriate implementation in the present application, in some further implementations, the perovskite thin film includes a perovskite metal halide, and halogen in the perovskite metal halide includes bromine and iodine.

Based on the compositional design of the perovskite metal halide in the perovskite thin film, bromine and iodine may be both disposed in a perovskite precursor solution. Various parameters such as dimension-related parameters (for example, the lengths, widths, depths, depth-to-width ratios, and average values of any one of the foregoing) and distribution-related parameters (for example, the average spacing, the area percentage of the concave grooves to the surface of the perovskite thin film, and the surface roughness of the perovskite thin film) of the concave grooves may be regulated by adjusting the ratio of the two elements, thereby flexibly adjusting the comprehensive enhancement of short-circuit current density and power conversion efficiency by the concave grooves.

In some implementations, halogen in the perovskite metal halide is bromine and iodine.

Based on any appropriate implementation in the present application, in some further implementations, the chemical composition of the perovskite metal halide is ABX₃. A is a monovalent cation, B is a divalent cation, and X is a monovalent anion. X in the perovskite metal halide includes Br⁻ and I⁻.

As a non-limiting example, A in the perovskite metal halide may include one or more of an alkali metal ion, a monovalent amine cation, and a monovalent amidinate cation. The alkali metal ion may include one or more of Cs⁺, K⁺, Rb⁺, and Li⁺.

A non-limiting example of a monovalent amine cation is (NR₂₁R₂₂R₂₃R₂₄)⁺, (R₂₁R₂₂N=CR₂₃R₂₄)⁺, (R₂₁R₂₂N-C(R₂₅)=NR₂₃R₂₄)⁺ or (R₂₁R₂₂N-C(NR₂₅R₂₆)=R₂₃R₂₄)⁺. R₂₁, R₂₂, R₂₃, R₂₄, R₂₅, and R₂₆ are each independently selected from H, C₁₋₂₀ alkyl, aryl, substituted C₁₋₂₀ alkyl or substituted aryl. "C₁₋₂₀ alkyl" in C₁₋₂₀ alkyl and in substituted C₁₋₂₀ alkyl is independently optionally C₁₋₁₅ alkyl, or further optionally, C₁₋₁₀ alkyl, still further optionally, C₁₋₈ alkyl, still further optionally, C₁₋₆ alkyl, still further optionally, C₁₋₄ alkyl, still further optionally, C₁₋₃ alkyl, and still further optionally, methyl. "Aryl" in aryl and substituted aryl is independently optionally C₆₋₂₀ aryl, further optionally, C₆₋₁₂ aryl, still further optionally, C₆₋₁₀ aryl, still further optionally, phenyl or naphthyl, and still further optionally, phenyl. Substituents in substituted C₁₋₂₀ alkyl and substituted aryl are each independently C₁₋₁₀ hydrocarbyl, further optionally, C₁₋₆ alkyl or C₆₋₁₀ aryl, and still further optionally, methyl or phenyl.

A non-limiting example of a monovalent amine cation is CH₃NH₃⁺ (methylammonium, MA⁺) or ammonium (NH₄⁺). A non-limiting example of a monovalent amidinate cation is NH₂CH=NH₂⁺ (formamidinium, which may be recorded as FA⁺).

In some implementations, in the perovskite metal halide, A includes CH(NH₂)₂⁺ and Cs⁺, and further, A may be a combination of CH(NH₂)₂⁺ and Cs⁺. Non-limitingly, a molar ratio of CH(NH₂)₂⁺ to Cs⁺ may be (1-a):a, where 0 < a < 1. a may be selected from any one of the following values or selected from an interval formed by any two of the following values: 0.1, 0.2, 0.3, 0.4, 0.5, 0.6, 0.7, 0.8, 0.9, and the like. a may alternatively be selected from the following range: 0.1 to 0.3, or the like.

As a non-limiting example, B in the perovskite metal halide may include one or more of Pb²⁺, Be²⁺, Mg²⁺, Ca²⁺, Sr²⁺, Ba²⁺, Zn²⁺, Ge²⁺, Fe²⁺, Co²⁺, and Ni²⁺.

In some implementations, in the perovskite metal halide, B includes Pb²⁺, and further, B may be Pb²⁺.

Based on any appropriate implementation in the present application, in some further implementations, an atomic molar ratio of bromine to iodine in the perovskite metal halide ranges from (3-y):y, where 0 < y ≤ 1.2, optionally, 0.5 ≤ y ≤ 1.2, and further optionally, 0.6 ≤ y ≤ 1.2. A non-limiting example of y may further include the following values: 0.2, 0.3, 0.4, 0.5, 0.6, 2/3, 0.7, 0.75, 0.8, 0.9, 1.0, 1.1, 1.2, and the like. y may alternatively be selected from an interval formed by any two of the foregoing values.

Based on the compositional design of the perovskite metal halide in the perovskite thin film, an atomic molar ratio of bromine to iodine in the perovskite precursor solution may be adjusted, so that the comprehensive performance in terms of short-circuit current density and power conversion efficiency of the perovskite solar cell can be improved.

In some implementations, the perovskite metal halide in the perovskite thin film may be any ABX₃ in the following Examples 1 to 8.

Based on any appropriate implementation in the present application, in some further implementations, the perovskite metal halide satisfies one or more of the following features:
Halogen in the perovskite metal halide is bromine and iodine.

In the perovskite metal halide, A includes CH(NH₂)₂⁺ and Cs⁺, B includes Pb²⁺, and X includes Br⁻ and I⁻. A molar ratio of CH(NH₂)₂⁺ to Cs⁺ is (1-a):a, where 0 < a < 1. Further, a may alternatively be any one of the following values, or may be selected from an interval formed by any two of the following values: 0.1, 0.2, 0.3, 0.4, 0.5, 0.6, 2/3, 0.7, 0.75, 0.8, and 0.9. A non-limiting example of a ranges from 0.1 to 0.3.

An appropriate perovskite metal halide may be selected according to performance and process control requirements of the perovskite thin film.

Based on any appropriate implementation in the present application, in some further implementations, a band gap of the perovskite thin film may range from 1.4 eV to 2.0 eV, and optionally, range from 1.6 eV to 1.8 eV.

In the present application, unless otherwise specified, the "band gap" has a well-known meaning in the art, and may be analyzed, compared, and confirmed using a conventional method in the technical field. Non-limitingly, a band gap parameter of a band gap of a material may be determined using an absorption spectrum or an emission spectrum of the material. Common optical methods include ultraviolet-visible absorption spectroscopy, photoluminescence spectroscopy, Raman spectroscopy, and the like.

When the perovskite thin film has the foregoing band gap, it is beneficial to improving the power density of devices. In combination with the foregoing concave groove design, it is beneficial to achieving better comprehensive performance of devices.

Based on any appropriate implementation in the present application, in some further implementations, at least some of perovskite grains in the perovskite thin film are continuous grains, and two ends of the continuous grains in the vertical direction are located on the surfaces of two sides of the perovskite thin film, respectively.

In the present application, unless otherwise specified, the "continuous grains" include continuous grains in the vertical direction. The continuous grains extend through the thickness of the perovskite thin film, so that two ends of the continuous grains in the vertical direction are respectively located on surfaces of two sides of the perovskite thin film.

When the perovskite grains in the perovskite thin film include continuous grains in the thickness direction (that is, in the vertical direction) of the perovskite thin film, it means that these perovskite grains continuously grow in the vertical direction, have minimal cracks in a vertical cross section of the perovskite thin film, and present as large-size grains penetrating in the vertical direction. In this case, the continuous grains penetrating the perovskite thin film in the vertical direction are beneficial to smoother and more efficient transport of carriers, and are beneficial to reducing grain boundary-induced non-radiative recombination, thereby improving the power conversion efficiency of devices.

Based on any appropriate implementation in the present application, in some further implementations, sizes of at least some of the continuous grains in a lateral direction are greater than or equal to 0.4 µm.

In the present application, unless otherwise specified, the "size in the lateral direction" of a perovskite grain in the perovskite thin film refers to the largest size of sizes in all directions of the grain in the lateral cross section of the thin film. Statistical analysis may be performed based on a vertical cross-sectional view and a lateral cross-sectional view of the perovskite thin film. The vertical cross-sectional view and the lateral cross-sectional view of the perovskite thin film may be obtained using methods such as scanning electron microscopy and optical microscopy. A semi-quantitative analysis may be performed on the sizes of the grains in the lateral direction based on the widths of the grains in the vertical cross-sectional view. Quantitative and statistical analysis data of the sizes of the grains in the lateral direction may also be obtained by analyzing vertical cross-sectional views at different positions and/or in different directions. Based on the lateral cross-sectional view, quantitative statistical analysis may be performed on the sizes of the grains in the lateral direction.

In the present application, when statistical analysis is performed on the sizes of the grains in the perovskite thin film, a data acquisition amount is properly selected based on the shapes, sizes, uniformity, distribution manner, and the like of the grains. For example, a minimum data acquisition amount may be determined by controlling a standard deviation of an average value to be less than or equal to 10% of the average value.

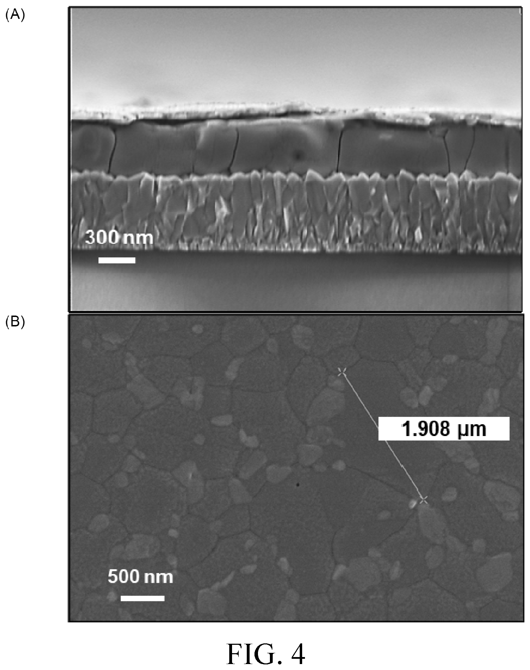

FIG. 4 is a scanning electron microscopy (SEM) image of a perovskite thin film according to an implementation of the present application, where (A) is a vertical cross-sectional view, and (B) is a lateral cross-sectional view. As can be seen from the vertical cross-sectional view, the perovskite grains in the perovskite thin film basically exist as vertically continuous grains. As can be further seen from the vertical cross-sectional view, these continuous grains also have relatively large sizes in the lateral direction. As can be seen from the lateral cross-sectional view, the proportion of the large-size grains in the perovskite thin film may be relatively large, and the size of each grain in the lateral direction may be measured, thereby performing statistical analysis on the sizes of the grains in the lateral direction in the perovskite thin film.

Non-limitingly, lateral sizes of at least some of the continuous grains may alternatively be greater than or equal to any one of the following sizes: 0.4 µm, 0.5 µm, 0.6 µm, 0.7 µm, 0.8 µm, 0.9 µm, 1.0 µm, 1.2 µm, and the like. In some implementations, sizes of at least some of the continuous grains in the lateral direction are greater than or equal to 0.6 µm, optionally, greater than or equal to 0.8 µm, and further optionally, greater than or equal to 1 µm.

Non-limitingly, the sizes of at least some of the continuous grains in the lateral direction may alternatively be selected from any one of the following sizes or an interval formed by any two of the following sizes: 0.4 µm, 0.5 µm, 0.6 µm, 0.7 µm, 0.8 µm, 0.9 µm, 1.0 µm, 1.2 µm, 1.4 µm, 1.5 µm, 1.6 µm, 1.8 µm, 2 µm, and the like.

In the present application, unless otherwise specified, the "at least some" in the "at least some continuous grains" may be based on a quantity of the grains, or may be based on an area in the lateral direction of the grains, or may be based on a volume of the grains. In the foregoing counting manner, in terms of values, "at least some" may represent being greater than or equal to any one of the following percentages: 30%, 40%, 50%, 60%, 70%, 80%, 90%, 95%, 99%, and the like.

In some implementations, an average size of the perovskite grains in the perovskite thin film in the lateral direction ranges from 0.6 µm to 2 µm, and optionally, ranges from 0.6 µm to 1.2 µm. Non-limitingly, the average size of the perovskite grains in the perovskite thin film in the lateral direction may alternatively be selected from any one of the following sizes or an interval formed by any two of the following sizes: 0.6 µm, 0.7 µm, 0.8 µm, 0.9 µm, 1.0 µm, 1.2 µm, 1.4 µm, 1.5 µm, 1.6 µm, 1.8 µm, 2 µm, and the like.

The quantity of boundaries between the perovskite grains can be adjusted by controlling the sizes of the continuous grains in the lateral direction. When the sizes in the lateral direction are larger, the quantity of through cracks between grains is smaller, and the perovskite thin film has fewer defects and higher quality. When the sizes of the continuous grains in the lateral direction are controlled to fall within the foregoing ranges, it is beneficial to fully utilize the positive effect of the foregoing continuous grains.

In some implementations, an average size of the continuous grains in the lateral direction ranges from 0.6 µm to 2 µm, and optionally, ranges from 0.6 µm to 1.2 µm. Non-limitingly, the average size of the continuous grains in the lateral direction may alternatively be selected from any one of the following sizes or an interval formed by any two of the following sizes: 0.6 µm, 0.7 µm, 0.8 µm, 0.9 µm, 1.0 µm, 1.2 µm, 1.4 µm, 1.5 µm, 1.6 µm, 1.8 µm, 2 µm, and the like.

The quantity of boundaries between the perovskite grains can be adjusted by controlling the sizes of the continuous grains in the lateral direction. When the sizes in the lateral direction are larger, the quantity of through cracks between grains is smaller, and the perovskite thin film has fewer defects and higher quality. When the sizes of the continuous grains in the lateral direction are controlled to fall within the foregoing ranges, it is beneficial to fully utilize the positive effect of the foregoing continuous grains.

Based on any appropriate implementation in the present application, in some further implementations, on a vertical cross section of the perovskite thin film, an area percentage of the continuous grains whose sizes in the lateral direction are greater than or equal to 1 µm relative to the vertical cross section is greater than or equal to 25%, optionally, greater than or equal to 28%, still further optionally, greater than or equal to 30%, still further optionally, greater than or equal to 40%, and still further optionally, greater than or equal to 50%. Non-limitingly, on the vertical cross section of the perovskite thin film, the area percentage of the continuous grains whose sizes in the lateral direction are greater than or equal to 1 µm relative to the vertical cross section may alternatively be selected from any one of the following percentages, or greater than or equal to any one of the following percentages, or selected from an interval formed by any two of the following percentages, or selected from an interval formed by any one of the following percentages and 100%: 25%, 26%, 28%, 30%, 35%, 40%, 45%, 50%, 55%, 60%, 70%, 71%, 72%, 75%, 80%, 85%, 90%, 95%, 96%, 98%, 99%, and the like. Non-limitingly, on the vertical cross section of the perovskite thin film, the area percentage of the continuous grains whose sizes in the lateral direction are greater than or equal to 1 µm relative to the vertical cross section may be selected from any appropriate range as follows: 25% to 100%, 28% to 100%, 30% to 100%, 40% to 100%, 25% to 90%, 28% to 90%, 30% to 90%, 40% to 90%, 25% to 80%, 28% to 80%, 30% to 80%, 40% to 80%, 25% to 75%, 28% to 75%, 30% to 75%, 40% to 75%, 28% to 71%, and the like.

Based on any appropriate implementation in the present application, in some further implementations, on a vertical cross section of the perovskite thin film, an area percentage of the continuous grains whose sizes in the lateral direction are greater than or equal to 1 µm relative to the vertical cross section is greater than or equal to 30%, optionally, greater than or equal to 40%, and further optionally, greater than or equal to 50%. Non-limitingly, the area percentage of the continuous grains whose sizes in the lateral direction are greater than or equal to 1 µm relative to the vertical cross section may alternatively be selected from any one of the following percentages, or greater than or equal to any one of the following percentages, or selected from an interval formed by any two of the following percentages: 30%, 35%, 40%, 45%, 50%, and the like.

The utilization of the effect of the continuous grains can be adjusted by controlling an area percentage of large-size continuous grains in the vertical cross section of the perovskite thin film. When the area percentage of the continuous grains having particular sizes in the lateral direction (sizes in the lateral direction greater than or equal to 1 µm) relative to the vertical cross section of the perovskite thin film is controlled to fall within the foregoing ranges, the advantages of the continuous grains are more fully exerted, thereby improving carrier transport and power conversion efficiency.

Based on any appropriate implementation in the present application, in some further implementations, on a lateral cross section of the perovskite thin film, an area percentage of the perovskite grains whose sizes in the lateral direction are greater than or equal to 1 µm relative to the non-smooth surface is greater than or equal to 40%, optionally, greater than or equal to 50%, and further optionally, greater than or equal to 60%. Non-limitingly, the area percentage of the perovskite grains whose sizes in the lateral direction are greater than or equal to 1 µm relative to the non-smooth surface may alternatively be selected from any one of the following percentages, or greater than or equal to any one of the following percentages, or selected from an interval formed by any two of the following percentages, or selected from an interval formed by any one of the following percentages and 100%: 40%, 45%, 50%, 55%, 60%, 70%, 71%, 72%, 75%, 80%, 85%, 90%, 95%, 96%, 98%, 99%, and the like. Non-limitingly, on the lateral cross section of the perovskite thin film, the area percentage of the perovskite grains whose sizes in the lateral direction are greater than or equal to 1 µm relative to the non-smooth surface may be selected from any appropriate range as follows: 40% to 100%, 45% to 100%, 50% to 100%, 60% to 100%, 70% to 100%, 80% to 100%, 40% to 95%, 45% to 95%, 50% to 95%, 60% to 95%, 70% to 95%, 80% to 95%, 40% to 90%, 45% to 90%, 50% to 90%, 60% to 90%, 70% to 90%, 80% to 90%, and the like.

Based on any appropriate implementation in the present application, in some further implementations, on a lateral cross section of the perovskite thin film, an area percentage of the perovskite grains whose sizes in the lateral direction are greater than or equal to 1 µm relative to the non-smooth surface is greater than or equal to 40%, optionally, greater than or equal to 50%, and further optionally, greater than or equal to 60%. Non-limitingly, the area percentage of the perovskite grains whose sizes in the lateral direction are greater than or equal to 1 µm relative to the non-smooth surface may alternatively be selected from any one of the following percentages, or greater than or equal to any one of the following percentages, or selected from an interval formed by any two of the following percentages: 40%, 45%, 50%, 55%, 60%, and the like.

The area percentage of large-size perovskite grains in the lateral cross section of the perovskite thin film is controlled, which is beneficial to reducing defects in the thin film and improving the quality of the thin film, thereby improving power conversion efficiency.

According to a second aspect of the present application, a perovskite solar cell is provided, including the perovskite thin film described in the first aspect of the present application. The non-smooth surface in the perovskite thin film forms a non-smooth interface with an adjacent structural layer.

In the present application, the non-smooth surface in the perovskite thin film may be disposed on an exit side of incident light.

When being used as a light-absorbing layer in the perovskite solar cell, the perovskite thin film described in the first aspect of the present application may also be referred to as a perovskite layer.

Based on any appropriate implementation in the present application, in some further implementations, the non-smooth surface in the perovskite thin film is located on the exit side of incident light. In this case, incident light enters the perovskite thin film and exits from the non-smooth surface, and through the light-reflection effect of concave grooves, more photons that exit the perovskite thin film are enabled to enter the perovskite thin film again.

Based on any appropriate implementation in the present application, in some further implementations, the present application provides a perovskite solar cell, including a charge transport layer and the perovskite thin film described in the first aspect of the present application. In some of the embodiments, the charge transport layer includes at least an electron transport layer.

In some implementations, the charge transport layer includes an electron transport layer and a hole transport layer. Further, the perovskite thin film is disposed between the electron transport layer and the hole transport layer.

Based on any appropriate implementation in the present application, in some further implementations, the present application provides a perovskite solar cell, including an electron transport layer, a hole transport layer, and the perovskite thin film described in the first aspect of the present application. The perovskite thin film is disposed between the electron transport layer and the hole transport layer.

Based on any appropriate implementation in the present application, in some further implementations, the non-smooth surface in the perovskite thin film is located on a side close to the electron transport layer.

Based on any appropriate implementation in the present application, in some further implementations, the hole transport layer is located between a first electrode and a perovskite layer, and the electron transport layer is located between a second electrode and the perovskite layer. In some other implementations, the electron transport layer is located between the first electrode and the perovskite layer, and the hole transport layer is located between the second electrode and the perovskite layer.

Based on any appropriate implementation in the present application, in some further implementations, the present application provides a perovskite solar cell, including a positive electrode, a negative electrode, and the perovskite thin film described in the first aspect of the present application. The perovskite thin film is disposed between the positive electrode and the negative electrode.

In the present application, unless otherwise specified, the perovskite thin film in the perovskite solar cell may be obtained through disassembling in the following manner, and the surface of the thin film is measured and analyzed. Taking an example in which the electron transport layer is a C₆₀/BCP and the second electrode located on a surface of a side of the electron transport layer away from a light-absorbing layer is a Cu electrode, the perovskite solar cell may be disassembled, the second electrode (for example, the Cu electrode) is removed, and the electron transport layer (for example, C₆₀/BCP) may be washed off using a corresponding antisolvent (for example, chlorobenzene) for the perovskite thin film. A manner of removing the second electrode is, for example, tape peeling.

Based on any appropriate implementation in the present application, in some further implementations, the present application provides a perovskite solar cell, including a positive electrode, an electron transport layer, the perovskite thin film described in the first aspect of the present application, a hole transport layer, and a negative electrode that are disposed in sequence. Further, the perovskite solar cell may be either an inverted p-i-n solar cell or a regular n-i-p solar cell.

During the operation of the perovskite solar cell, after a light-absorbing layer is illuminated, internal electrons gain energy and break free from the constraints of the light-absorbing layer to form negatively charged electron carriers, and positively charged hole carriers are formed simultaneously, thereby creating electron-hole pairs. The free electrons and free holes are transported in opposite directions through respective transport layers, causing the electrons and holes to flow to constitute an electric current, thereby achieving the conversion of light energy into electrical energy. Further, upon photon absorption, a perovskite layer generates electron-hole pairs through excitation. The electron-hole pairs further dissociate into oppositely charged free carriers. The free electrons are transported toward the positive electrode through the electron transport layer, while the free holes are transported toward the negative electrode through the hole transport layer. The two types of free carriers are collected by corresponding electrodes, thereby further forming a photocurrent in the circuit of the perovskite solar cell.

The electron transport layer can extract and transport electron carriers while blocking the passage of free holes.

The hole transport layer can extract and transport hole carriers while blocking the passage of free electrons.

It may be understood that the perovskite solar cell further includes two electrodes. One of the two electrodes is used as the positive electrode, and may collect the electron carriers transported through the electron transport layer. The other is used as the negative electrode, and may collect the hole carriers transported through the hole transport layer.

Based on any appropriate implementation in the present application, in some further implementations, an electronic transport material in the electron transport layer may include, but is not limited to, one or more of the following materials and derivatives thereof: imide compounds, quinone compounds, fullerenes and their derivatives, methoxytriphenylamine-fluorinated formamidinium (OMeTPA-FA), calcium titanate (CaTiO₃), lithium fluoride (LiF), calcium fluoride (CaF₂), poly(3,4-ethylenedioxythiophene):poly(styrenesulfonate) (PEDOT:PSS), poly(3-hexylthiophene) (P3HT), triptycene-cored triphenylamine (H101), 3,4-ethylenedioxythiophene-methoxytriphenylamine (EDOT-OMeTPA), N-(4-aniline)carbazole-spirobifluorene (CzPAF-SBF), polythiophene, metal oxide, silicon oxide (SiO₂), strontium titanate (SrTiO₃), and copper(I) thiocyanate (CuSCN). The metal may include one or more of Mg, Ni, Cd, Zn, In, Pb, Mo, W, Sb, Bi, Cu, Hg, Ti, Ag, Mn, Fe, V, Sn, Zr, Sr, Ga, and Cr.

Based on any appropriate implementation in the present application, in some further implementations, the electronic transport material in the electron transport layer may include, but is not limited to, one or more of the following materials: bathocuproine, [6,6]-phenyl-C₆₁-butyric acid isomethyl ester, [6,6]-phenyl-C₇₁-butyric acid methyl ester, C₆₀, C₇₀, tin oxide (SnOₓ, where x ranges from 1.5 to 2), zinc oxide and its derivatives, and modified forms of any one of the aforementioned materials obtained through doping or passivation.

Based on any appropriate implementation in the present application, in some further implementations, a hole transport material in the hole transport layer may include, but is not limited to, one or more of the following materials and derivatives thereof: 2,2',7,7'-tetrakis[N,N-bis(4-methoxyphenyl)amino]-9,9'-spirobifluorene (Spiro-OMeTAD), poly(triarylamine) (PTAA), nickel oxide (NiOₓ), poly(3,4-ethylenedioxythiophene):poly(styrenesulfonate) (PEDOT:PSS), WO₃, among other materials that can transport holes while blocking electrons.

Based on any appropriate implementation in the present application, in some further implementations, the hole transport material in the hole transport layer may include, but is not limited to, one or more of a carbazole phosphonate material (a non-limiting example of the carbazole phosphonate material is [4-(3,6-dimethoxy-9H-carbazol-9-yl)butyl]phosphonic acid, doped or passivated [4-(3,6-dimethoxy-9H-carbazol-9-yl)butyl]phosphonic acid, or the like), poly[bis(4-phenyl)(2,4,6-trimethylphenyl)amine], poly(3-hexylthiophene), triptycene-cored triphenylamine, 3,4-ethylenedioxythiophene-methoxytriphenylamine, N-(4-aniline)carbazole-spirobifluorene, poly(3,4-ethylenedioxythiophene):poly(styrenesulfonate), polythiophene, nickel oxide, molybdenum oxide, cuprous iodide, cuprous oxide, and derivatives thereof. The hole transport material in the hole transport layer may further include one or more of any one of the foregoing materials, modified forms of any of the aforementioned materials obtained through doping or passivation, and the like.

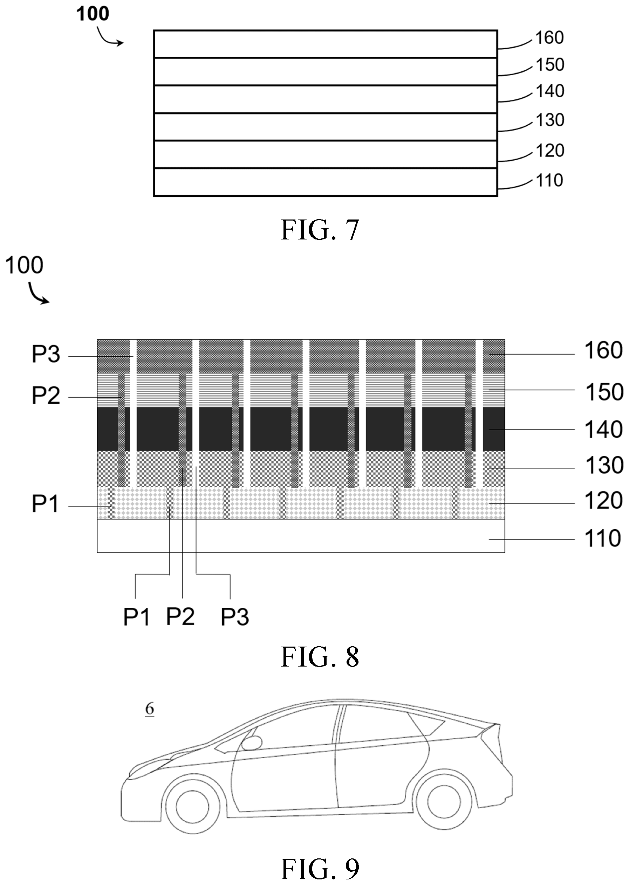

Based on any appropriate implementation in the present application, in some further implementations, a perovskite solar cell 100 includes the structure shown in FIG. 7, and includes a substrate layer 110, a first electrode 120, a first charge transport layer 130, a perovskite layer 140, a second charge transport layer 150, and a second electrode 160 that are disposed in sequence. Further, the structural layers shown in the figure are stacked in sequence.

Based on any appropriate implementation in the present application, in some further implementations, one of the "first charge transport layer" and the "second charge transport layer" is an electron transport layer, and the other is a hole transport layer. In some implementations, the first charge transport layer is an electron transport layer. In some implementations, the first charge transport layer is a hole transport layer.

Based on any appropriate implementation in the present application, in some further implementations, at least one of the "first electrode" and the "second electrode" is a transparent electrode.

Based on any appropriate implementation in the present application, in some further implementations, one of the "first electrode" and the "second electrode" is a transparent electrode for light incidence. In some implementations, the first electrode is a transparent electrode. Based on any appropriate implementation in the present application, in some further implementations, the non-smooth surface in the perovskite thin film faces away from a transparent electrode. In this case, incident light enters the perovskite thin film through the transparent electrode and exits from the non-smooth surface, and through the light-reflection effect of concave grooves, more photons that exit the perovskite thin film are enabled to enter the perovskite thin film again. In addition, the perovskite thin film may be formed on a substrate including a transparent electrode. In this case, after the non-smooth surface is formed, fewer subsequent processes are required to manufacture the perovskite solar cell, resulting in minimal impact on the performance of the perovskite layer. A non-limiting example of the substrate including the transparent electrode is, for example, that the substrate including a transparent electrode includes the transparent electrode, the first charge transport layer, and the perovskite thin film stacked in sequence. The first charge transport layer may be a hole transport layer or an electron transport layer. In some of the examples, the first charge transport layer is a hole transport layer. Further, a side of the transparent electrode facing away from the perovskite thin film is further provided with a substrate layer.

Based on any appropriate implementation in the present application, in some further implementations, a transparent conductive material included in the transparent electrode may include a conductive oxide. Non-limitingly, the conductive oxide may include one or more of indium tin oxide, flourine-doped tin oxide, indium-doped tungsten oxide, indium-doped zinc oxide, and aluminum-doped zinc oxide.

Based on any appropriate implementation in the present application, in some further implementations, a material of the transparent electrode may be, for example, but is not limited to, one or more of the following materials: FTO (flourine-doped tin oxide), ITO (tin-doped indium oxide), AZO (aluminum-doped zinc oxide), BZO (boron-doped zinc oxide), IZO (indium zinc oxide), and IWO (tungsten-doped indium oxide).

Based on any appropriate implementation in the present application, in some further implementations, one of the first electrode and the second electrode includes a conductive material. Optionally, the second electrode includes a conductive material. The conductive material may be an organic conductive material, an inorganic conductive material, or a combination thereof. A non-limiting example of the inorganic conductive material is a metal conductive material. Further, the metal conductive material may include any one of gold (Au), silver (Ag), copper (Cu), aluminum (Al), nickel (Ni), chromium (Cr), bismuth (Bi), platinum (Pt), magnesium (Mg), or any appropriate mixture of the foregoing elements. The conductive material may include a conductive oxide. Further, the conductive material may be a conductive oxide. A non-limiting example of the conductive oxide may include one or more of FTO, ITO, IWO, AZO, and the like.

Based on any appropriate implementation in the present application, in some further implementations, one of the first electrode and the second electrode is a metal electrode. Optionally, the second electrode is a metal electrode. The metal electrode may include one or more of gold (Au), silver (Ag), copper (Cu), aluminum (Al), nickel (Ni), chromium (Cr), bismuth (Bi), platinum (Pt), magnesium (Mg), molybdenum (Mo), tungsten (W), and the like.

Based on any appropriate implementation in the present application, in some further implementations, the perovskite solar cell includes a first electrode, a first charge transport layer, a perovskite layer, a second charge transport layer, and a second electrode that are disposed in sequence.

The perovskite layer is the perovskite thin film described in the first aspect of the present application.

One of the first charge transport layer and the second charge transport layer is an electron transport layer, and the other is a hole transport layer.

At least one of the first electrode and the second electrode is a transparent electrode.

The non-smooth surface in the perovskite thin film faces away from one transparent electrode.

The first electrode may be a transparent electrode. The second electrode may also be a transparent electrode. The first electrode and the second electrode may both be transparent electrodes. In this case, the non-smooth surface of the perovskite thin film may face either of the first electrode and the second electrode.

In some implementations, the perovskite solar cell includes a substrate layer. The substrate may be disposed at the first electrode or may be disposed at the second electrode. In some implementations, the perovskite solar cell includes a substrate layer, a first electrode, a first charge transport layer, a perovskite layer, a second charge transport layer, and a second electrode that are disposed in sequence. In some implementations, the perovskite solar cell includes a substrate layer, a second electrode, a second charge transport layer, a perovskite layer, a first charge transport layer, and a first electrode that are disposed in sequence.

The substrate layer in the implementations or embodiments of the present application may be, but is not limited to, a glass substrate or a flexible substrate. Non-limitingly, the flexible substrate may include one or more materials of polyethylene terephthalate, polyimide, polyethylene, polypropylene, polystyrene, and poly(ethylene naphthalate). Optionally, the first electrode is a transparent electrode for light incidence.

Based on any appropriate implementation in the present application, in some further implementations, the substrate layer is a flexible substrate layer. Further, a material of the substrate layer may be, for example (but is not limited to), an organic polymer material. Further, one or more of the following materials (the materials are not limited thereto) may be mixed in different ratios: polyvinyl alcohol (PVA), polyethylene terephthalate (PET), polyimide (PI), poly(ethylene naphthalate) (PEN), and polydimethylsiloxane (PDMS).

Based on any appropriate implementation in the present application, in some further implementations, the perovskite solar cell is either an inverted p-i-n solar cell or a regular n-i-p solar cell.

The perovskite solar cell provided in the present application may be of a regular type or an inverted type.

In some implementations, the perovskite solar cell has a p-i-n structure.

Based on any appropriate implementation in the present application, in some further implementations, for the regular type, the perovskite solar cell includes a transparent electrode and an electron transport layer, a perovskite layer, a hole transport layer, and a second electrode that are stacked in sequence on the transparent electrode.

Based on any appropriate implementation in the present application, in some further implementations, for the inverted type, the perovskite solar cell includes a transparent electrode and a hole transport layer, a perovskite layer, an electron transport layer, and a second electrode that are stacked in sequence on the transparent electrode. The transparent electrode is used for light incidence, and the transparent electrode is used as the first electrode.

Based on any appropriate implementation in the present application, in some further implementations, the perovskite solar cell includes the following structures that are disposed in sequence: a substrate layer (which may be a glass substrate or a flexible substrate), a first electrode, a hole transport layer, a perovskite layer, an electron transport layer, and a second electrode.

Based on any appropriate implementation in the present application, in some further implementations, the perovskite solar cell includes the following structures that are disposed in sequence: a substrate layer (a glass substrate or a flexible substrate), a first electrode, an electron transport layer, a perovskite layer, a hole transport layer, and a second electrode. Optionally, the first electrode is a transparent electrode for light incidence. For the definition of the flexible substrate, refer to the foregoing text.

In some implementations, the perovskite solar cell is provided with three types of cross-layer etched regions P1, P2, and P3. The perovskite solar cell is divided into a plurality of series-connected sub-cells using an etched region group including a P1 etched region, a P2 etched region, and a P3 etched region. Each sub-cell includes one P1 etched region, one P2 etched region, and one P3 etched region arranged in sequence, and the P2 etched region is located between the P1 etched region and the P3 etched region. The P1 etched region, the P2 etched region, and the P3 etched region may be respectively connected to structural layers disposed at intervals, so that the structural layers between the first electrode and the second electrode form a circuit, and the perovskite solar cell forms a perovskite solar cell assembly. P1, P2, and P3 may be each independently a linear etched region, also referred to as an etch line. P1, P2, and P3 may be each independently a laser etched region. The quantities of P1, P2, and P3 correspond to the quantity of the sub-cells. Non-limitingly, P1, P2, and P3 may be disposed in the following manner: P1 is used for dividing the first electrode, and two ends of P1 are respectively connected to the first charge transport layer and the substrate layer. P2 is used for penetrating and dividing the second charge transport layer, the perovskite layer, and the first charge transport layer, and two ends of the P2 etched region are respectively connected to the second electrode and the first electrode. P3 is used for penetrating and dividing the second electrode, the second charge transport layer, the perovskite layer, and the first charge transport layer. One end of P3 is connected to a surface of the first electrode, and the other end of P3 extends out of an outer side surface of the second electrode.

In some implementations, the perovskite solar cell includes the structure shown in FIG. 8 (which is a vertical cross-sectional structural view of the device), and includes a substrate layer 110, a first electrode 120, a first charge transport layer 130, a perovskite layer 140, a second charge transport layer 150, and a second electrode 160 that are stacked in sequence, and three types of etched regions P1, P2, and P3 are further disposed to divide the perovskite solar cell into a plurality of series-connected sub-cells. P1 is used for dividing the first electrode, P2 is used for penetrating and dividing the second charge transport layer, the perovskite layer, and the first charge transport layer, and P3 is used for penetrating and dividing the second electrode, the second charge transport layer, the perovskite layer, and the first charge transport layer.

In some implementations, the substrate layer 110 in the structure shown in FIG. 8 is a light-incident glass substrate.

In some implementations, a filling material in the P1 etched region in the perovskite solar cell may be the same as that in the first charge transport layer.

In some implementations, a filling material in the P2 etched region in the perovskite solar cell may be the same as that in the second electrode.

In some implementations, a width of P1 ranges from 10 µm to 50 µm, and is, for example, 30 µm.

In some implementations, a width of P2 ranges from 10 µm to 200 µm, and is, for example, 150 µm. Further, a spacing between P2 and P1 may range from 20 µm to 80 µm, and is, for example, 20 µm.

In some implementations, a width of P3 ranges from 10 µm to 50 µm, and is, for example, 15 µm. Further, a spacing between P3 and P2 may range from 20 µm to 40 µm, and is, for example, 20 µm.

The specification of the perovskite solar cell is not particularly limited, and may be, but is not limited to, 300 mm×300 mm.

It may be understood that the structure of the perovskite solar cell in the present application may be not limited to the structural layers listed above. Other functional layers such as a buffer layer and an interlayer may further be introduced as required. In some embodiments, a buffer layer having an appropriate energy level may be disposed in the perovskite solar cell to lower an energy level barrier, promote energy level matching, and improve carrier extraction efficiency, and also achieve one or more functions of passivating interfacial defect states, protecting the light-absorbing layer, suppress oxidation and decomposition of the solar cell by water modules and oxygen, improve the power conversion efficiency, and improve the stability of the perovskite solar cell. Based on different positions of the buffer layers, four types of buffer layers may be included: a buffer layer between the hole transport layer and an anode, a buffer layer between the electron transport layer and a cathode, a buffer layer between the hole transport layer and the absorbing layer, and a buffer layer between the electron transport layer and the absorbing layer. A material that can be used for the buffer layer in the perovskite solar cell may include, but is not limited to: Cu₂O, NiO, AZO, and TiO₂. In some embodiments, the interlayer may be disposed between the electron transport layer and the second electrode. An example of a material of the interlayer is bathocuproine (BCP).

A diamond scribe may be used to cleave a sample of the perovskite solar cell in a vertical direction, and morphological observation, for example, SEM measurement, is performed with a vertical cross section facing upward.

The perovskite solar cell of the perovskite thin film may be further vertically sliced in a thickness direction to obtain a vertical cross section, to analyze elemental composition and content with reference to an element analysis method. For example, measurement and analysis may be performed with reference to continuous slicing in the vertical direction using a cryo-focused ion beam (FIB), SEM morphological observation of a cross section, energy-dispersive spectroscopy (EDS) coupled with elemental energy spectrum analysis, and three-dimensional reconstruction analysis software.

According to a third aspect of the present application, a method for preparing a perovskite solar cell is provided, and may be used to prepare the perovskite solar cell described in the second aspect of the present application.

In some implementations, a method for preparing a perovskite solar cell is included, including the following steps: sequentially stacking a first charge transport layer, a perovskite layer, a second charge transport layer, and a second electrode on a surface of a side of a first electrode to prepare the perovskite solar cell, where the perovskite layer is the perovskite thin film defined in the first aspect of the present application.

A method for stacking the perovskite layer on a side of the first charge transport layer facing away from the first electrode includes the following steps:
coating a precursor solution of the perovskite layer onto a surface of the side of the first charge transport layer facing away from the first electrode; and
performing vacuum flash evaporation on the precursor solution, and performing annealing to form the perovskite layer, where the non-smooth surface may be formed on a side of the perovskite layer facing away from the first electrode.

The perovskite layer is prepared through a vacuum flash evaporation process. The foregoing concave groove structure can be formed on a surface of at least one side of the perovskite layer, thereby improving light utilization and improving the comprehensive performance in terms of short-circuit current density and power conversion efficiency of the perovskite solar cell. In addition, the formation of large-size continuous grains may also be promoted, thereby promoting carrier transport and power conversion efficiency.

Based on any appropriate implementation in the present application, in some further implementations, a solvent in the precursor solution of the perovskite layer includes N,N-dimethylformamide and dimethyl sulfoxide.

Optionally, a solvent in the precursor solution of the perovskite layer is a combination of N,N-dimethylformamide and dimethyl sulfoxide.

Optionally, a volume ratio of N,N-dimethylformamide to dimethyl sulfoxide ranges from (2 to 6):1, and further optionally, (3 to 5):1.

Based on any appropriate implementation in the present application, in some further implementations, the method for preparing a perovskite solar cell satisfies one or more of the following features (any numerical parameter in the following features may alternatively be selected from any appropriate value or range in the context):

the vacuum flash evaporation is performed under a negative pressure condition, and a pressure of the negative pressure condition is less than or equal to 100 Pa, and optionally, ranges from 60 Pa to 100 Pa;
duration of the vacuum flash evaporation ranges from 15 s to 100 s, and optionally, 20 s to 60 s;
a temperature of the vacuum flash evaporation ranges from 20°C to 40°C, and optionally, 20°C to 30°C;
the annealing is performed using a hot plate method, optionally, a hot plate ranging from 90°C to 110°C is used, and further optionally, a hot plate ranging from 95°C to 105°C is used; and
an annealing time of the annealing ranges from 5 min to 20 min, and optionally, ranges from 8 min to 12 min.

The negative pressure condition may range from (but not limited to) 60 Pa to 100 Pa, and may alternatively be selected from any one of the following pressures or an interval formed by any two of the following pressures: 60 Pa, 70 Pa, 80 Pa, 90 Pa, and the like.

A temperature at which the vacuum flash evaporation is performed may range from (but not limited to) 10°C to 40°C, or may be selected from any one of the following temperatures or an interval formed by any two of the following temperatures: 10°C, 15°C, 16°C, 18°C, 20°C, 22°C, 25°C, 30°C, 35°C, and 40°C. The temperature at which the vacuum flash evaporation is performed may alternatively be within the following ranges: 18°C to 30°C, 18°C to 25°C, 18°C to 22°C, and the like.

Duration for which the vacuum flash evaporation is performed may be, but is not limited to, 15 s to 100 s, and may alternatively be selected from any one of the following duration values or an interval formed by any two of the following duration values: 15 s, 20 s, 25 s, 30 s, 35 s, 40 s, 50 s, 60 s, 70 s, 80 s, 90 s, 100 s, or the like.

Based on any appropriate implementation in the present application, in some further implementations, a coating manner in the step of coating a precursor solution of the perovskite layer onto a surface of the side of the first charge transport layer facing away from the first electrode is spin coating.

Optionally, a spin-coating speed ranges from 2000 rpm to 6000 rpm, and optionally, ranges from 2000 rpm to 4000 rpm.

The grain size and the surface morphology of the perovskite layer are regulated as required by adjusting one or more parameters in a preparation process of the perovskite layer, so that the comprehensive performance in terms of short-circuit current density and power conversion efficiency of the perovskite solar cell can be better improved through process parameter optimization.

The structural layers other than the perovskite layer in the perovskite solar cell may be prepared using one or more of the following manners, including (but not limited to): chemical bath deposition, electrochemical deposition, chemical vapor deposition, thermal co-evaporation, atomic layer deposition, magnetron sputtering, precursor solution spin-coating, precursor solution slot-die coating, precursor solution doctor blading, mechanical pressing, and the like. An appropriate manner may be selected based on material properties of structural layers for stacking with adjacent structural layers. In some implementations, the structural layers other than the perovskite layer in the perovskite solar cell may be prepared using one or more of the following manners, including (but not limited to): thermal evaporation and precursor solution coating. The precursor solution coating may be precursor solution spin-coating.

In some implementations, the perovskite solar cell is prepared using a method including the following steps:
S10: Perform P1 etching on the first electrode: performing P1 etching on FTO conductive glass stacked on a glass substrate to expose the glass substrate to obtain a first substrate, where FTO is the first electrode, and a substrate layer is the glass substrate. The first charge transport layer may be prepared after cleaning.

In a non-limiting example, 20 pieces of FTO conductive glass with a specification of 2.0 cm×2.0 cm are taken, and two ends of the FTO conductive glass are etched using P1 laser to remove FTO of 0.35 cm to expose the glass substrate. The etched FTO conductive glass is sequentially ultrasonically cleaned using a cleaning liquid, deionized water, and ethanol for several times. The FTO conductive glass is blown with a nitrogen gun to remove the solvent and is placed in an ultraviolet ozone cleaner for further cleaning.

S20: Prepare the first charge transport layer: spin-coating a solution containing a hole transport material on a side surface of the first electrode of the first substrate, and performing annealing under a heating condition to form a hole transport layer.

A thickness of the hole transport layer may range from 2 nm to 20 nm.

In a non-limiting example, a solution containing the hole transport material is spin-coated at 2000 rpm in a glovebox on an FTO substrate obtained after ultraviolet ozone treatment, and annealing is performed on a hot plate of 100°C for 10 min to form the hole transport layer. The hole transport material may be a self-assembled molecular solution with a concentration of 0.5 mg/mL, and the solvent may be isopropanol. A non-limiting example of the self-assembled molecule is one or more carbazole phosphonate molecules of MeO-2PACz([2-(3,6-dimethoxy-9H-carbazol-9-yl)ethyl]phosphonic acid), 2PACz([2-(9H-carbazol-9-yl)ethyl]phosphonic acid), 4PACz([4-(9H-carbazol-9-yl)butyl]phosphonic acid), 6PACz(2-(9h-carbazol-9-yl)hexyl]phosphonic acid), Me-4PACz([4-(3,6-dimethyl-9H-carbazol-9-yl)butyl]phosphonic acid), Me-2PACz((3,6-dimethyl-9h-carbazol-9-yl)butyl] phosphonic acid), and the like.

S30: Prepare the perovskite layer: spin-coating a perovskite precursor solution on the hole transport layer, performing vacuum flash evaporation, and then performing annealing under a heating condition, to form the perovskite thin film (also recorded as the perovskite layer).

It may be understood that when the perovskite solar cell has an appropriate size, for example, for some small-size perovskite solar cells, an etching step in a process of preparing the perovskite solar cell may alternatively be omitted.

In a non-limiting example, the perovskite precursor solution is spin-coated on the hole transport layer at 2000 rpm to 6000 rpm, and the coated hole transport layer is then placed in vacuum flash evaporation equipment to be treated for 20 s to 60 s, and is transferred to a hot plate of 100°C to perform annealing for 10 min, to form the perovskite layer. The perovskite precursor solution includes a perovskite precursor material. The perovskite precursor material includes a monovalent cation A, a divalent cation B, and a monovalent anion X. The solvent may be a mixed solvent of DMF and DMSO with a volume ratio of (2 to 6):1.

The perovskite precursor solution may be prepared by using the following method: dissolving the perovskite precursor material in the solvent based on a stoichiometric ratio of a perovskite metal halide in the perovskite layer to form a mixed solution, performing stirring for 1 h, and performing filtration using a 0.22 µm organic filter membrane, to obtain the perovskite precursor solution. Taking an example in which the perovskite metal halide is CsₐFA₁₋ₐPbI_{3-y}Br_{y} (0 < a < 1, 0 < y ≤ 1.2), the perovskite precursor material may be a combination of lead iodide, lead bromide, formamidinium bromide, formamidinium iodide, cesium iodide, and cesium bromide, and an active material of a perovskite absorbing layer is a CsFA system.

S40: Prepare the second charge transport layer and the second electrode: successively depositing an electron transport layer and the second electrode through evaporation on the perovskite layer.

In a non-limiting example, the electron transport layer (C₆₀), an interlayer (BCP), and the second electrode (Cu) are deposited on the perovskite layer using an evaporation coating machine, thicknesses of which are respectively 25 nm, 8 nm, and 100 nm, to obtain the perovskite solar cell. The first charge transport layer, the perovskite layer, and the second charge transport layer form a photoelectric conversion layer.

After the electron transport layer is formed, P2 etching is performed, an etching depth reaches a surface of a side of the first electrode close to the hole transport layer, and the formed P2 etching divides the photoelectric conversion layer. Refer to FIG. 8.

After the second electrode is formed, P3 etching is performed, an etching depth reaches a surface of a side of the first electrode close to the hole transport layer, and the formed P3 etching divides the photoelectric conversion layer and the second electrode. Refer to FIG. 8.

According to a fourth aspect of the present application, a power consuming apparatus is provided, including at least one of the perovskite thin film described in the first aspect of the present application, the perovskite solar cell described in the second aspect of the present application, or a perovskite solar cell prepared using the method for preparing a perovskite solar cell described in the third aspect of the present application.

According to a fifth aspect of the present application, a power generation apparatus, including at least one of the perovskite thin film described in the first aspect of the present application, the perovskite solar cell described in the second aspect of the present application, or a perovskite solar cell prepared using the method for preparing a perovskite solar cell described in the third aspect of the present application.

In some of the embodiments, the perovskite solar cell may be used as a power generation device of the power consuming apparatus. Types of the power generation apparatus and the power generation device may include, but are not limited to, integrated power generation. The position of the power generation apparatus or the power generation device may include, but is not limited to, a roof or a truck lid of a vehicle.

Further, the power consuming apparatus may include, but is not limited to, a mobile device (for example, a mobile phone, or a laptop computer), an electric vehicle, an electric train, a ship, a satellite, and a power generation system.

FIG. 9 shows an example of a power consuming apparatus. The power consuming apparatus 6 is a vehicle, and may further be an all-electric vehicle, a hybrid electric vehicle, a plugin hybrid electric vehicle, or the like.

For another example, the power consuming apparatus may be a mobile phone, a tablet computer, a notebook computer, a calculator, or the like.

For another example, the power consuming apparatus may be a wearable device, for example, a watch.

Some embodiments of the present application will be described hereinafter. The embodiments described below are exemplary and only used to explain the present application, and should not be construed as a limitation on the present application. Where techniques or conditions are not indicated in the embodiments, the techniques or conditions described above or in the literatures in the art or described in the product specifications are followed. The reagents or instruments for which no manufacturers are noted are all commercially available common products, or can be conventionally synthesized with commercially available products.

In the following embodiments, the room temperature refers to 20°C to 30°C.

### Method for preparing a perovskite solar cell: preparing a perovskite layer using vacuum flash evaporation

S10: Perform P1 etching on the first electrode: performing P1 etching on FTO conductive glass stacked on a glass substrate to expose the glass substrate to obtain a first substrate, where FTO is the first electrode, and a substrate layer is the glass substrate. The etched FTO conductive glass was sequentially ultrasonically cleaned using a cleaning liquid, deionized water, and ethanol several times. The FTO conductive glass was blown with a nitrogen gun to remove the solvent and was placed in an ultraviolet ozone cleaner for further cleaning.

S20: Prepare a first charge transport layer: spin-coating a solution containing the hole transport material at 2000 rpm in a glovebox on an FTO substrate obtained after ultraviolet ozone treatment, and performing annealing on a hot plate of 100°C for 10 min to form the hole transport layer. The hole transport material was a self-assembled molecular (MeO-2PACz) solution with a concentration of 0.5 mg/mL, and the solvent was isopropanol.

S30: Prepare a perovskite layer: spin-coating a perovskite precursor solution on the hole transport layer at 4000 rpm, then placing the coated hole transport layer in vacuum flash evaporation equipment to perform vacuum flash evaporation under conditions of 20°C and 70 Pa for 30 s, and transferring the treated hole transport layer to a hot plate of 100°C to perform annealing for 10 min, to form the perovskite layer. The perovskite precursor solution includes a perovskite precursor material. The perovskite precursor material was a combination of lead iodide, lead bromide, formamidinium bromide, formamidinium iodide, cesium iodide, and cesium bromide, and an active material of a perovskite absorbing layer was a CsFA system. The solvent was a mixed solvent of DMF and DMSO with a volume ratio of 4:1. The corresponding perovskite metal halide was CsₐFA₁₋ₐPbI_{3-y}Br_{y} (0 < a < 1, 0 < y ≤ 1.2).

The perovskite precursor solution was prepared by using the following method: dissolving the perovskite precursor material in the solvent based on a stoichiometric ratio of a perovskite metal halide in the perovskite layer to form a mixed solution, performing stirring for 1 h, and performing filtration using a 0.22 µm organic filter membrane, to obtain the perovskite precursor solution.

S40: Deposit the electron transport layer (C₆₀), an interlayer (BCP), and the second electrode (Cu) on the perovskite layer using an evaporation coating machine, thicknesses of which are respectively 25 nm, 8 nm, and 100 nm, to obtain the perovskite solar cell.

In **Example 1**, parameters of vacuum flash evaporation during preparation of the perovskite layer were vacuum flash evaporation under conditions of 20°C and 70 Pa for 30 s. In CsₐFA₁₋ₐPbI_{3-y}Br_{y} (0 < a < 1, 0 < y ≤ 1.2), a was 0.2, and y was 1.2.

The perovskite solar cells were prepared in **Examples 2 to 8** using methods basically the same as the method in Example 1. Differences lie only in that the compositions of the perovskite metal halides were different. For preparation parameters, refer to Table 1.

The value of y in ABX₃ shown in CsₐFA₁₋ₐPbI_{3-y}Br_{y} was adjusted in Examples 2 to 5, and the value of a in CsₐFA₁₋ₐPbI_{3-y}Br_{y} was adjusted in Examples 6 and 7.

The perovskite solar cell was prepared in Example 8 using a method basically the same as that in Example 1, and a difference lies in that the type of the perovskite metal halide ABX₃ was changed. The difference between Example 8 and Example 1 lies in that A in ABX₃ was changed to obtain Cs_{0.1}FA_{0.8}MA_{0.1}, and ABX₃ was Cs_{0.1}FA_{0.8}MA_{0.1}PbI_{3-y}Br_{y}.

### Comparative Examples 1 to 3: Prepare a perovskite layer using an antisolvent method

A perovskite precursor solution the same as that in Example 1 was used in Comparative Example 1, but an antisolvent method was used for preparation. In Comparative Examples 2 and 3, the value of y was adjusted based on Comparative Example 1. For the perovskite metal halides in the perovskite precursor solutions, refer to Table 1.

S10: Perform P1 etching on the first electrode: performing P1 etching on FTO conductive glass stacked on a glass substrate to expose the glass substrate to obtain a first substrate, where FTO is the first electrode, and a substrate layer is the glass substrate. The etched FTO conductive glass was sequentially ultrasonically cleaned using a cleaning liquid, deionized water, and ethanol several times. The FTO conductive glass was blown with a nitrogen gun to remove the solvent and was placed in an ultraviolet ozone cleaner for further cleaning.

S20: Prepare a first charge transport layer: spin-coating a solution containing the hole transport material at 2000 rpm in a glovebox on an FTO substrate obtained after ultraviolet ozone treatment, and performing annealing on a hot plate of 100°C for 10 min to form the hole transport layer. The hole transport material was a MeO-2PACz solution with a concentration of 0.5 mg/mL, and the solvent was isopropanol.

S30: Prepare a perovskite layer: spin-coating a perovskite precursor solution on the hole transport layer at 2000 rpm to 6000 rpm, a total spin-coating time being 50 s, adding 200 µL of a chlorobenzene solution dropwise at 30 s, and after the spin-coating ends, transferring the thin film to a hot plate of 100°C to perform annealing for 10 min, to form the perovskite layer. The perovskite precursor solution includes a perovskite precursor material. The perovskite precursor material was a combination of lead iodide, lead bromide, formamidinium bromide, formamidinium iodide, cesium iodide, and cesium bromide, and an active material of a perovskite absorbing layer was a CsFA system. The solvent was a mixed solvent of DMF and DMSO with a volume ratio of 4:1. The corresponding perovskite metal halide was CsₐFA₁₋ₐPbI_{3-y}Br_{y} (0 < a < 1, 0 < y ≤ 1.2). For the elemental composition of the perovskite metal halide, refer to Table 1.

The perovskite precursor solution was prepared by using the following method: dissolving the perovskite precursor material in the solvent based on a stoichiometric ratio of a perovskite metal halide in the perovskite layer to form a mixed solution, performing stirring for 1 h, and performing filtration using a 0.22 µm organic filter membrane, to obtain the perovskite precursor solution.

S40: Deposit the electron transport layer (C₆₀), an interlayer (BCP), and the second electrode (Cu) on the perovskite layer using an evaporation coating machine, thicknesses of which are respectively 25 nm, 8 nm, and 100 nm, to obtain the perovskite solar cell.

Methods basically the same as the method in Example 1 was used in **Comparative Examples 4 and 5.** For differences, refer to Table 1.

In Comparative Example 4, the perovskite solar cell was prepared using a method basically the same as that in Example 1, and a difference lies in that X in ABX₃ was only bromine, where y = 3.

**In Comparative Example 5,** the perovskite solar cell was prepared using a method basically the same as that in Example 1, and a difference from Example 1 lies in that X in ABX₃ was only iodine, where y = 0.

**In Comparative Example 6,** the perovskite solar cell was prepared using a method basically the same as that in Example 1, and a difference lies in that the temperature of vacuum flash evaporation was changed from 20°C to 50°C.

**In Comparative Example 7,** the perovskite solar cell was prepared using a method basically the same as that in Example 1, and differences lie in that the type of the perovskite metal halide ABX₃ was changed and FA was changed into MA.

In **Comparative Example 8,** the perovskite solar cell was prepared using a method basically the same as that in Example 1, and differences lie in that the type of the perovskite metal halide ABX₃ was changed and Pb used as B was changed into Pb_{0.5}Sn_{0.5}.

**Table 1**

| No. | Perovskite metal halide in the perovskite layer | | | Parameters of vacuum flash evaporation for the perovskite layer |
|---|---|---|---|---|
| | ABX₃ | a | y | |
| Example 1 | CsₐFA₁₋ₐPbI_{3-y}Br_{y} | 0.2 | 1.2 | 20°C, 70 Pa, 30 s |
| Example 2 | CsₐFA₁₋ₐPbI_{3-y}Br_{y} | 0.2 | 0.9 | 20°C, 70 Pa, 30 s |
| Example 3 | CsₐFA₁₋ₐPbI_{3-y}Br_{y} | 0.2 | 0.7 | 20°C, 70 Pa, 30 s |
| Example 4 | CsₐFA₁₋ₐPbI_{3-y}Br_{y} | 0.2 | 0.5 | 20°C, 70 Pa, 30 s |
| Example 5 | CsₐFA₁₋ₐPbI_{3-y}Br_{y} | 0.2 | 0.3 | 20°C, 70 Pa, 30 s |
| Example 6 | CsₐFA₁₋ₐPbI_{3-y}Br_{y} | 0.3 | 1.2 | 20°C, 70 Pa, 30 s |
| Example 7 | CsₐFA₁₋ₐPbI_{3-y}Br_{y} | 0.1 | 1.2 | 20°C, 70 Pa, 30 s |
| Example 8 | Cs_{0.1}FA_{0.8}MA_{0.1}PbI_{3-y}Br_{y} | / | 1.2 | 20°C, 70 Pa, 30 s |
| Comparative Example 1 | CsₐFA₁₋ₐPbI_{3-y}Br_{y} | 0.2 | 1.2 | Preparation using an antisolvent method |
| Comparative Example 2 | CsₐFA_{1-aP}bI_{3-y}Br_{y} | 0.2 | 0.01 | Preparation using an antisolvent method |
| Comparative Example 3 | CsₐFA₁₋ₐPbI_{3-y}Br_{y} | 0.2 | 1.5 | Preparation using an antisolvent method |
| Comparative Example 4 | CsₐFA₁₋ₐPbBr₃ | 0.2 | y=3 | Vacuum flash evaporation 20°C, 70 Pa, 30 s |
| Comparative Example 5 | CsₐFA₁₋ₐPbI₃ | 0.2 | y = 0 | 20°C, 70 Pa, 30 s |
| Comparative Example 6 | CsₐFA₁₋ₐPbI_{3-y}Br_{y} | 0.2 | 1.2 | Vacuum flash evaporation 50°C, 70 Pa, 30 s |
| Comparative Example 7 | CsₐMA₁₋ₐPbI_{3-y}Br_{y} | 0.2 | 1.2 | 20°C, 70 Pa, 30 s |
| Comparative Example 8 | CsₐFA₁₋ₐPb_{0.5}Sn_{0.5}I_{3-y}Br_{y} | 0.2 | 1.2 | 20°C, 70 Pa, 30 s |

### Measurement and analysis methods

### 1. Morphology and structure measurement

A sample on which a perovskite thin film has been deposited is fixed to a sample holder by a conductive tape to perform SEM measurement. Scanning electron microscopy (SEM) is an experimental observation technique that bridges the gap between transmission electron microscopy and optical microscopy. SEM is an electron-optical instrument that operates by scanning the surface of an observed sample with an electron beam, and generates images by collecting a series of electronic information generated from the interaction between the electron beam and the sample and converting, amplifying, and digitally processing the information. The instrument features a large depth of field, a large field of view, and images with superior three-dimensional appearance, enabling effective analysis of the surface morphology of the sample. The magnification can be adjusted by changing the scanning amplitude of the electron beam across the surface of the measurement sample, enabling observation of the measurement sample at magnifications ranging from approximately 20× to 200000×, for example, magnifications such as 7K, 10K, 20K, and 30K, where 1K = 1000×. SEM allows for observation of the crystallization (for example, grain size, grain thickness, and "whether continuous grains whose sizes in the lateral direction are greater than or equal to 1 µm exist") and morphological features of a perovskite sample.

An SEM measurement object is a thin-film assembly in which a perovskite thin film has been deposited on a hole transport layer and in which an electron transport layer has not been deposited. Measurement and analysis may be performed in a vertical direction and a lateral direction.
(1) An observed surface was a surface of an exposed side of the perovskite layer.
(2) A piece of thin film with an area of 1×0.5 cm² was cut from the prepared perovskite thin film using a diamond scribe, and was adhered on an SEM sampling stage with a vertical cross section facing upward. The crystallization quality and crystal thickness were observed using SEM.

Related information such as "the area percentage of the continuous grains whose sizes in the lateral direction are greater than or equal to 1 µm in the vertical cross section" may be obtained based on an SEM image of the vertical cross section with reference to analysis software such as Image-J.

### 2. Analysis of surface roughness and structural dimensions of the perovskite thin film.

A stylus profilometer (a probe-type profilometer) is used to measure the surface roughness and the concave groove structures of the perovskite thin film.

A to-be-measured sample is a thin-film assembly in which the perovskite layer has been deposited on the hole transport layer and in which the electron transport layer has not been disposed (step S30 has been completed and step S40 has not been performed), and a surface of a side of the perovskite layer is used as a measurement surface.

Measurement conditions: The probe directly contacts the surface to record contour changes, so that two-dimensional contour changes can be obtained and linear roughness can be calculated.

Measurement is performed in a contact-motion mode: As the stylus slides gently along the measured surface, the microscopic peaks and valleys cause the stylus to move vertically along the peaks and valleys while sliding. The movement trajectory of the stylus reflects the surface contour.

Measurement results and analysis method: A morphological curve (which may also be referred to as a surface roughness curve) of the surface may be obtained, a "valley" in the curve corresponds to a concave groove, and a region between two nearest neighboring peaks whose fluctuation depth is greater than or equal to 100 nm is considered as one "valley". The surface roughness of the to-be-measured surface may be obtained by collecting statistics of "valley depths" in the surface roughness curve. Further, dimension parameters such as widths, an average width, lengths, aspect ratios, half-height widths, an average half-height width, depths, an average depth, depth-to-width ratios, and an average depth-to-width ratio of the concave grooves may be obtained through analysis. In addition, these dimension parameters of the concave grooves may alternatively be obtained through observation and analysis from an SEM image of the vertical cross section with a particular magnification, for example, a magnification of 20K, 30K, or 40K.

### 3. Optical microscope observation

A to-be-measured sample is a thin-film assembly in which the perovskite layer has been deposited on the hole transport layer and in which the electron transport layer has not been disposed (step S30 has been completed and step S40 has not been performed), and a surface of a side of the perovskite layer is used as a measurement surface. A dimension of the assembly in the lateral direction is recorded as A2.

Instrument: An optical microscope (Keyence VHX-S650E), in which the perovskite thin film is directly placed under a light beam, and a focal length is adjusted to perform observation.

A to-be-measured sample is a thin-film assembly in which the perovskite layer has been deposited on the hole transport layer and in which the electron transport layer has not been disposed (step S30 has been completed and step S40 has not been performed), and a surface of a side of the perovskite layer is used as a measurement surface.

### Measurement and analysis methods:

An area range of at least 960000 µm² is selected to perform statistical analysis.
(1) A surface morphology image of the perovskite thin film may be obtained. Areas surrounded by the contours of the concave grooves in the image are recorded as A1. The "percentage of the sum of the projection areas of the concave grooves in the vertical direction relative to the projection area of the non-smooth surface in the vertical direction (recorded as R1)" is equal to A1/A2 × 100%.
(2) Spacings between a plurality of adjacent concave grooves may alternatively be measured according to a center connection line analysis of the widths of the concave grooves, and an average value is calculated to obtain an average spacing between the concave grooves.

### 4. Performance measurement of a perovskite solar cell

The to-be-measured perovskite solar cell is connected to a dedicated capacitor and is used as a variable load. In a process of charging the capacitor by the to-be-measured perovskite solar cell, current and voltage sampling are performed, corresponding current and voltage data is recorded and is drawn into a current-voltage characteristic curve (I-V curve), and electric performance parameters are calculated, to obtain measured values of an open circuit voltage (Voc), a short-circuit current density (Jsc), a fill factor (FF), and power conversion efficiency (PCE).

The power conversion efficiency is calculated as follows: PCE = Pout/Popt = Voc × Jsc × [(Vmpp × Jmpp)/(Voc × Jsc)]/Popt = Voc × Jsc × FF/Popt

Pout, Popt, Vmpp, and Jmpp represent the working output power, incident light power, voltage at the maximum power point, and current at the maximum power point of the solar cell, respectively.

For measurement and analysis results, refer to Table 2 and Table 3.

### Analysis of measurement results

FIG. 1 is an optical micrograph of a surface morphology of a perovskite thin film prepared through vacuum flash evaporation according to Example 1 of the present application. In the micrograph, concave grooves are relatively uniformly distributed on the surface of the perovskite thin film as a whole, and dimensions of the concave grooves and raised regions between the concave grooves in a lateral direction form a well-matched combination, exhibiting a wrinkled morphology on the whole.

It can be further seen from FIG. 1 that most of the concave grooves have aspect ratios greater than 1, and satisfy various aspect ratio ranges, including, but not limited to, concave grooves satisfying the following aspect ratios: ≥ 2, ≥ 3, ≥ 5, and the like.

It can be further seen from FIG. 1 that corners exist in extension directions of some of the concave grooves. Non-linear lines exist in extension directions of some of the concave grooves. Intersection nodes exist between some adjacent concave grooves. That is, some adjacent concave grooves are in communication with each other through the intersection nodes.

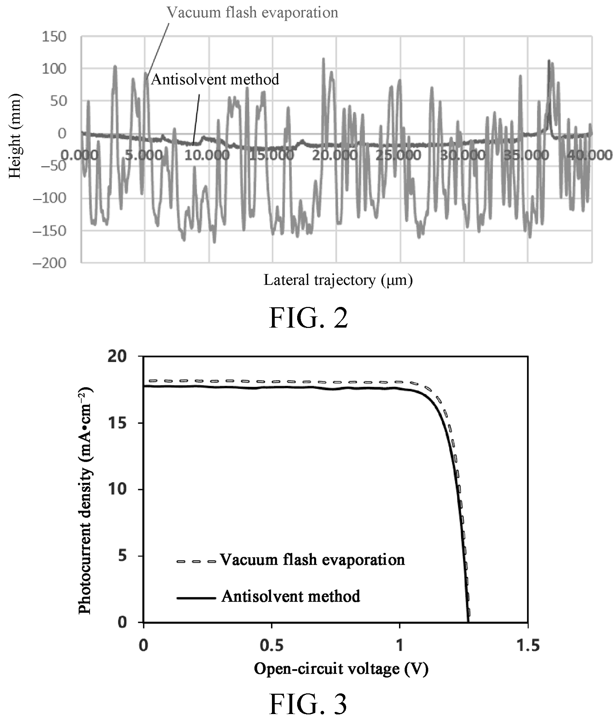

FIG. 2 is a diagram of comparison between measurements of surface roughness of perovskite thin films prepared according to Example 1 and Comparative Example 1 of the present application. A horizontal coordinate axis is a measurement trajectory in the lateral direction, recorded as a "lateral trajectory". The vacuum flash evaporation corresponds to Example 1, and the antisolvent method corresponds to Comparative Example 1. It can be learned that the surface of the perovskite thin film in Example 1 prepared using vacuum flash evaporation is a non-smooth surface and has particular roughness. The surface of the perovskite thin film in Comparative Example 1 prepared using the antisolvent method is relatively smooth on the whole. According to FIG. 1, the "percentage of the sum of the projection areas of the concave grooves in the vertical direction relative to the projection area of the non-smooth surface in the vertical direction (which may be recorded as R1)" and the average spacing between the concave grooves may be further obtained through analysis.

According to FIG. 2, it can be seen that the concave grooves have depths that mainly fall between 100 nm and 250 nm and half-height widths that mainly fall between 200 nm and 600 nm. In addition, parameters such as the widths, the average width, the half-height widths, the average half-height width, the depths, the average depth, the depth-to-width ratios, and the average depth-to-width ratio of the concave grooves may also be obtained through analysis, and may be summarized in Tables 2 and 3.

It can be further seen from FIG. 2 that some of the concave grooves have opening widths greater than bottom widths. Some of the concave grooves have opening widths greater than half-height widths that are in turn greater than bottom widths.

FIG. 3 is a current-voltage characteristic curve of a perovskite thin film prepared by vacuum flash evaporation according to Example 1 of the present application. It can be seen that the short-circuit current density of Example 1 is higher than that of Comparative Example 1, and the solar cell efficiency of Example 1 is higher than that of Comparative Example 1.

FIG. 4 is a scanning electron microscopy (SEM) image of a perovskite thin film prepared by vacuum flash evaporation according to Example 1 of the present application, where (A) is a vertical cross-sectional view, and (B) is a lateral planar view.

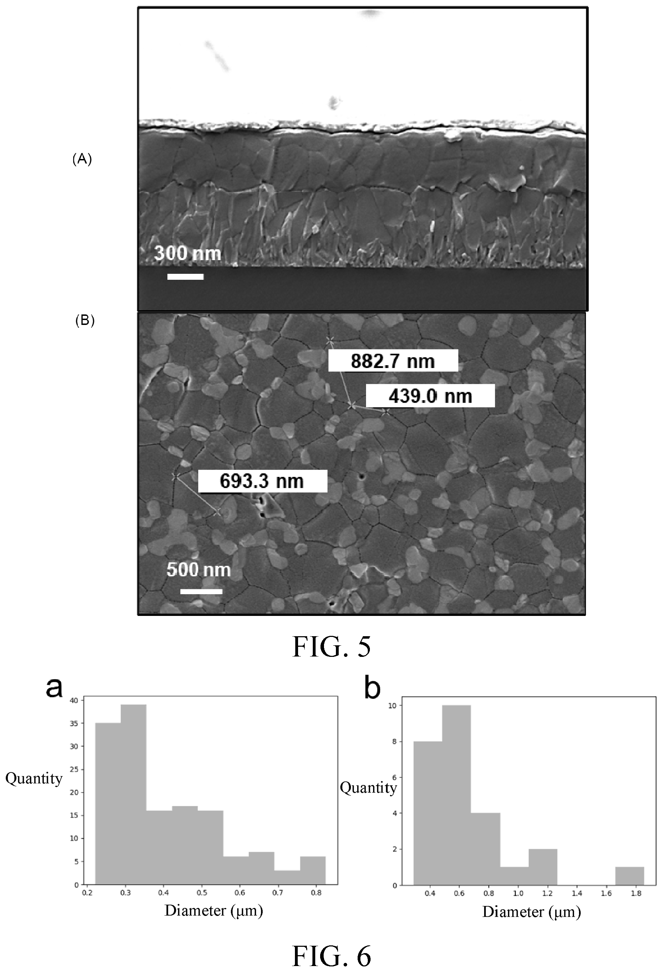

FIG. 5 is a scanning electron microscopy (SEM) image of a perovskite thin film prepared by an antisolvent method according to Comparative Example 1 of the present application, where (A) is a vertical cross-sectional view, and (B) is a lateral planar view. The surface of the perovskite thin film formed in Comparative Example 1 is relatively smooth, and basically has no vertically continuous grains and also slightly small grain sizes.

FIG. 6 is a statistical histogram of grain sizes of perovskite thin films prepared in Example 1 and Comparative Example 1 of the present application, where a is Example 1 in which vacuum flash evaporation is used, b is Comparative Example 1 in which an antisolvent method is used, and statistical collection is performed based on maximum diameters of grains of the perovskite thin films within a statistical range in FIG. 6.

According to FIG. 4 and b in FIG. 6, the perovskite thin film prepared using vacuum flash evaporation in Example 1 has high perovskite crystallization quality, and the perovskite grains in the perovskite layer have a large average size and minimal defects. According to a vertical cross-sectional view in A in FIG. 4, it can be learned that the perovskite thin film prepared in Example 1 has minimal cracks in the vertical cross section of the perovskite thin film, and vertically continuous grains are formed. Sizes of some of the continuous grains in the lateral direction are greater than or equal to 1 µm. The area percentage of the continuous grains whose sizes in the lateral direction are greater than or equal to 1 µm relative to the vertical cross section is greater than 40%. In a lateral cross-sectional view of B in FIG. 4, a large quantity of large-size perovskite grains may also be observed in the perovskite layer in Example 1, and sizes of the grains in the lateral direction may reach 1 µm to 2 µm. According to B in FIG. 4 and b in FIG. 6, the area percentage of the perovskite grains whose sizes in the lateral direction are greater than or equal to 1 µm relative to the non-smooth surface is relatively high.

According to FIG. 5 and a in FIG. 6, in the perovskite thin film prepared using the antisolvent method in Comparative Example 1, the average size of the perovskite grains is relatively small, and the thin film has a large number of defects. Many fragmented crystals are observed in the vertical cross section in A in FIG. 5, and basically no continuous grains exist. That is, it is difficult for most grains to penetrate the thin film in the vertical direction, easily hindering a transport process of carriers. Sizes of grains in the lateral direction in the lateral cross-sectional view in B in FIG. 5 are clearly smaller than sizes of grains in the lateral direction in the lateral cross-sectional view in B in FIG. 4 in Example 1.

In the examples (Examples 1 to 8), concave grooves having aspect ratios greater than 1 exist in all measured regions, and satisfy various aspect ratio ranges, including, but not limited to, concave grooves satisfying the following aspect ratios: ≥ 2, ≥ 3, ≥ 5, and the like. In addition, for the concave grooves, a width range is mainly ±0.1 µm of the average width, a depth range is mainly ±10 nm or ±5 nm of the average depth, and a depth-to-width ratio range is mainly ±0.03, ±0.02, or ±0.01 of the average depth-to-width ratio.

The surfaces of the perovskite thin films in Comparative Examples 1 to 8 are all relatively flat surfaces, and basically no concave groove structure appears. A perovskite precursor solution the same as that in Example 1 was used in Comparative Example 1, but an antisolvent method was used for preparation. In Comparative Examples 2 and 3, the value of y was adjusted based on Comparative Example 1, and an antisolvent method was also used for preparation. The halogen X in the perovskite metal halide in Comparative Example 4 is only bromine (y = 3), and the halogen X in the perovskite metal halide in Comparative Example 5 is only iodine (y = 0). The temperature of vacuum flash evaporation treatment is relatively high (50°C) in Comparative Example 6. FA is replaced with MA for the monovalent cation A in the perovskite metal halide in Comparative Example 7. Pb is replaced with Pb_{0.5}Sn_{0.5} for the divalent cation B in the perovskite metal halide in Comparative Example 8.

**Table 2**

| No. | Do concave grooves with aspect ratios greater than 1 exist? | Average width of the concave grooves (µm) | Average depth of the concave grooves (nm) | Average depth-to-width ratio of the concave grooves | Average spacing between the concave grooves (µm) |
|---|---|---|---|---|---|
| Example 1 | Yes | 0.7 | 198 | 0.28 | 15.0 |
| Example 2 | Yes | 0.8 | 162 | 0.21 | 15.5 |
| Example 3 | Yes | 0.9 | 149 | 0.17 | 16.0 |
| Example 4 | Yes | 1.0 | 141 | 0.13 | 16.5 |
| Example 5 | Yes | 1.1 | 130 | 0.11 | 17.0 |
| Example 6 | Yes | 0.8 | 157 | 0.21 | 15.5 |
| Example 7 | Yes | 0.6 | 201 | 0.33 | 14.0 |
| Example 8 | Yes | 0.8 | 195 | 0.26 | 14.2 |
| Comparative Example 1 | No | / | / | / | / |
| Comparative Example 2 | No | / | / | / | / |
| Comparative Example 3 | No | / | / | / | / |
| Comparative Example 4 | No | / | / | / | / |
| Comparative Example 5 | No | / | / | / | / |
| Comparative Example 6 | No | / | / | / | / |
| Comparative Example 7 | No | / | / | / | / |
| Comparative Example 8 | No | / | / | / | / |

In Examples 1 to 8, the average depth of the concave grooves in the measured region is substantially equal to the surface roughness in value.

**Table 3**

| No. | R1 | Do continuous grains whose sizes in the lateral direction are greater than or equal to 1 µm exist? | Area percentage of the continuous grains whose sizes in the lateral direction are greater than or equal to 1 µm in the vertical cross section | Open-circuit voltage VoC (V) | Short-circuit current density Jsc (mA/cm²) | Fill factor FF (%) | Power conversion efficiency PCE (%) |
|---|---|---|---|---|---|---|---|
| Example 1 | Satisfy ≥ 50% | Yes | 71% | 1.25 | 18.0 | 81.0 | 18.5 |
| Example 2 | Satisfy ≥ 50% | Yes | 62% | 1.20 | 18.5 | 80.0 | 17.8 |
| Example 3 | Satisfy ≥ 50% | Yes | 53% | 1.16 | 19.0 | 80.5 | 17.8 |
| Example 4 | Satisfy ≥ 50% | Yes | 39% | 1.10 | 20.3 | 80.6 | 18.0 |
| Example 5 | Satisfy ≥ 50% | Yes | 28% | 1.02 | 20.8 | 80.2 | 17.2 |
| Example 6 | Satisfy ≥ 50% | Yes | 50% | 1.20 | 17.5 | 80.3 | 16.9 |
| Example 7 | Satisfy ≥ 50% | Yes | 45% | 1.18 | 17.8 | 80.2 | 16.8 |
| Example 8 | Satisfy ≥ 50% | Yes | 51% | 1.23 | 17.9 | 80.0 | 17.6 |
| Comparative Example 1 | 0% | No | 0 | 1.25 | 17.5 | 80.6 | 17.6 |
| Comparative Example 2 | 0% | No | 0 | 1.04 | 20.0 | 80.3 | 16.7 |
| Comparative Example 3 | 0% | No | 0 | 1.20 | 17.3 | 79.0 | 16.5 |
| Comparative Example 4 | 0% | No | 0 | 1.10 | 16.3 | 75.6 | 13.5 |
| Comparative Example 5 | 0% | No | 0 | 1.05 | 19.2 | 79.8 | 16.8 |
| Comparative Example 6 | 0% | Yes | 70% | 1.23 | 17.2 | 81.0 | 17.1 |
| Comparative Example 7 | 0% | No | 0 | 1.23 | 17.6 | 80.0 | 17.3 |
| Comparative Example 8 | 0% | No | 0 | 0.75 | 29.5 | 79.5 | 17.5 |

In Table 3, R1 denotes the percentage of the sum of the projection areas of the concave grooves in the vertical direction relative to the projection area of the non-smooth surface in the vertical direction.

The above description of the various implementations and embodiments tends to emphasize the differences between the various implementations and embodiments. The implementations and embodiments may be cross-referenced for identical or similar parts, and details are not described herein again for the sake of brevity.

Technical features of the foregoing implementations and embodiments may be randomly combined. To make description concise, not all possible combinations of the technical features in the foregoing implementations and embodiments are described. However, the combinations of these technical features shall be considered as falling within the scope recorded by this specification provided that no conflict exists.

It should be noted that the present application is not limited to the implementations and embodiments above. The above-described implementations and embodiments are merely exemplary, and implementations having substantially the same technical idea and the same effects within the scope of the technical solution of the present application are all included in the technical scope of the present application. The above implementations and embodiments are only several implementations of the present application, which are described in detail, without limitation to the scope of the patent. In addition, other manners constructed by applying various modifications conceivable to a person skilled in the art to the implementations or embodiments and combining some of the constituent elements of the implementations and embodiments without departing from the scope of the essence of the present application are also included in the scope of the present application.

## Claims

1. A perovskite thin film, wherein a thickness direction of the perovskite thin film is recorded as a vertical direction, the perovskite thin film has two surfaces facing away from each other in the vertical direction, at least one surface is a non-smooth surface, and the non-smooth surface is provided with a plurality of concave grooves; and
at least a portion of a side surface of each of the concave grooves forms an inclination angle relative to the vertical direction.

2. The perovskite thin film according to claim 1, wherein surface roughness of non-smooth regions formed by at least some of the concave grooves is greater than or equal to 100 nm.

3. The perovskite thin film according to claim 1, wherein surface roughness of non-smooth regions formed by at least some of the concave grooves ranges from 100 nm to 250 nm.

4. The perovskite thin film according to claim 2 or 3, wherein the surface roughness is measured using stylus profilometry.

5. The perovskite thin film according to any one of claims 1 to 4, wherein a percentage of a sum of projection areas of the concave grooves in the vertical direction relative to a projection area of the non-smooth surface in the vertical direction is greater than or equal to 10%.

6. The perovskite thin film according to claim 5, wherein the percentage of the sum of the projection areas of the concave grooves in the vertical direction relative to the projection area of the non-smooth surface in the vertical direction ranges from 50% to 100%.

7. The perovskite thin film according to any one of claims 1 to 6, wherein the concave grooves satisfy one or more of the following features:
aspect ratios of at least some of the concave grooves are greater than 1;
widths of at least some of the concave grooves are less than or equal to 1.2 µm;
half-height widths of at least some of the concave grooves are less than or equal to 1 µm;
depths of at least some of the concave grooves are greater than or equal to 100 nm; and
depth-to-width ratios of at least some of the concave grooves range from 0.08 to 0.5.

8. The perovskite thin film according to claim 7, wherein the concave grooves satisfy one or more of the following features:
aspect ratios of at least some of the concave grooves range from 2 to 8;
widths of at least some of the concave grooves range from 0.6 µm to 1.1 µm;
half-height widths of at least some of the concave grooves range from 0.2 µm to 0.6 µm;
depths of at least some of the concave grooves range from 100 nm to 250 nm; and
depth-to-width ratios of at least some of the concave grooves range from 0.1 to 0.5.

9. The perovskite thin film according to any one of claims 1 to 8, wherein the concave grooves satisfy one or more of the following features:
in at least some regions of the non-smooth surface, an average width of the concave grooves ranges from 0.2 µm to 1 µm;
in at least some regions of the non-smooth surface, an average half-height width of the concave grooves ranges from 0.1 µm to 1 µm;
in at least some regions of the non-smooth surface, an average depth of the concave grooves ranges from 100 nm to 500 nm; and
in at least some regions of the non-smooth surface, an average depth-to-width ratio of the concave grooves ranges from 0.08 to 0.5.

10. The perovskite thin film according to claim 9, wherein the concave grooves satisfy one or more of the following features:
in at least some regions of the non-smooth surface, an average width of the concave grooves ranges from 0.6 µm to 1.1 µm;
in at least some regions of the non-smooth surface, an average half-height width of the concave grooves ranges from 0.2 µm to 0.6 µm;
in at least some regions of the non-smooth surface, an average depth of the concave grooves ranges from 100 nm to 250 nm; and
in at least some regions of the non-smooth surface, an average depth-to-width ratio of the concave grooves ranges from 0.1 to 0.5.

11. The perovskite thin film according to any one of claims 1 to 10, wherein in at least some regions of the non-smooth surface, an average spacing between the concave grooves ranges from 1 µm to 20 µm.

12. The perovskite thin film according to claim 11, wherein in at least some regions of the non-smooth surface, an average spacing between the concave grooves ranges from 10 µm to 20 µm.

13. The perovskite thin film according to any one of claims 1 to 12, wherein at least some of the concave grooves have opening widths greater than bottom widths.

14. The perovskite thin film according to claim 13, wherein based on the projection areas of the concave grooves in the vertical direction, at least some of the concave grooves have opening widths greater than half-height widths that are in turn greater than bottom widths.

15. The perovskite thin film according to any one of claims 1 to 14, wherein the concave grooves satisfy one or more of the following features:
corners exist in extension directions of at least some of the concave grooves;
at least segments of lengths in extension directions of at least some of the concave grooves are non-linear; and
intersection nodes exist between at least some of the concave grooves.

16. The perovskite thin film according to any one of claims 1 to 15, wherein the perovskite thin film comprises a perovskite metal halide, and halogen in the perovskite metal halide comprises bromine and iodine.

17. The perovskite thin film according to claim 16, wherein an atomic molar ratio of bromine to iodine in the perovskite metal halide ranges from (3-y):y, wherein 0 < y ≤ 1.2.

18. The perovskite thin film according to claim 17, wherein 0.6 ≤ y ≤ 1.2.

19. The perovskite thin film according to any one of claims 1 to 18, wherein a band gap of the perovskite thin film ranges from 1.4 eV to 2.0 eV.

20. The perovskite thin film according to any one of claims 1 to 19, wherein at least some of perovskite grains in the perovskite thin film are continuous grains, and two ends of the continuous grains in the vertical direction are located on the surfaces of two sides of the perovskite thin film, respectively.

21. The perovskite thin film according to claim 20, wherein sizes of at least some of the continuous grains in a lateral direction are greater than or equal to 0.4 µm; and the lateral direction is orthogonal to the vertical direction.

22. The perovskite thin film according to claim 21, wherein an average size of the continuous grains in the lateral direction ranges from 0.6 µm to 2 µm.

23. The perovskite thin film according to any one of claims 20 to 22, wherein on a vertical cross section of the perovskite thin film, an area percentage of the continuous grains whose sizes in the lateral direction are greater than or equal to 1 µm relative to the vertical cross section is greater than or equal to 25%.

24. The perovskite thin film according to claim 23, wherein on the vertical cross section of the perovskite thin film, the area percentage of the continuous grains whose sizes in the lateral direction are greater than or equal to 1 µm relative to the vertical cross section ranges from 30% to 100%.

25. The perovskite thin film according to claim 23, wherein on the vertical cross section of the perovskite thin film, the area percentage of the continuous grains whose sizes in the lateral direction are greater than or equal to 1 µm relative to the vertical cross section ranges from 25% to 80%.

26. A perovskite solar cell, comprising the perovskite thin film according to any one of claims 1 to 25, wherein the non-smooth surface in the perovskite thin film forms a non-smooth interface with an adjacent structural layer.

27. The perovskite solar cell according to claim 26, comprising a first electrode, a first charge transport layer, a perovskite layer, a second charge transport layer, and a second electrode that are disposed in sequence, wherein
the perovskite layer is the perovskite thin film according to any one of claims 1 to 25;
one of the first charge transport layer and the second charge transport layer is an electron transport layer, and the other is a hole transport layer;
at least one of the first electrode and the second electrode is a transparent electrode; and
the non-smooth surface in the perovskite thin film faces away from one transparent electrode.

28. A method for preparing a perovskite solar cell, comprising the following steps: sequentially stacking a first charge transport layer, a perovskite layer, a second charge transport layer, and a second electrode on a surface of a side of a first electrode to prepare the perovskite solar cell, wherein the perovskite layer is the perovskite thin film defined in any one of claims 1 to 25, wherein
a method for stacking the perovskite layer on a side of the first charge transport layer facing away from the first electrode comprises the following steps:
coating a precursor solution of the perovskite layer onto a surface of the side of the first charge transport layer facing away from the first electrode; and
performing vacuum flash evaporation on the precursor solution, and performing annealing to form the perovskite layer, wherein the non-smooth surface is formed on a side of the perovskite layer facing away from the first electrode.

29. The method for preparing a perovskite solar cell according to claim 28, wherein a solvent in the precursor solution of the perovskite layer comprises N,N-dimethylformamide and dimethyl sulfoxide; and
a volume ratio of N,N-dimethylformamide to dimethyl sulfoxide ranges from (2 to 6):1.

30. The method for preparing a perovskite solar cell according to claim 28 or 29, wherein the method for preparing a perovskite solar cell satisfy one or more of the following features:
the vacuum flash evaporation is performed under a negative pressure condition, and a pressure of the negative pressure condition ranges from 50 Pa to 100 Pa;
duration of the vacuum flash evaporation ranges from 15 s to 100 s;
a temperature of the vacuum flash evaporation ranges from 10°C to 40°C;
the annealing is performed using a hot plate method, and a hot plate ranging from 90°C to 110°C is used; and
an annealing time of the annealing ranges from 5 min to 20 min.

31. The method for preparing a perovskite solar cell according to any one of claims 28 to 30, wherein a coating manner in the step of coating a precursor solution of the perovskite layer onto a surface of the side of the first charge transport layer facing away from the first electrode is spin coating, and a spin-coating speed ranges from 2000 rpm to 6000 rpm.

32. A power consuming apparatus, comprising at least one of the perovskite thin film according to any one of claims 1 to 25, the perovskite solar cell according to claim 26 or 27, or a perovskite solar cell prepared using the method for preparing a perovskite solar cell according to any one of claims 28 to 31.

33. A power generation apparatus, comprising at least one of the perovskite thin film according to any one of claims 1 to 25, the perovskite solar cell according to claim 26 or 27, or a perovskite solar cell prepared using the method for preparing a perovskite solar cell according to any one of claims 28 to 31.
